# EUROPÄISCHE PATENTSCHRIFT

(11) **EP 1 243 947 B1**
(45) Veröffentlichungstag und Bekanntmachung des Hinweises auf die Patenterteilung: **06.05.2009**
(21) Anmeldenummer: 02006299.8
(22) Anmeldetag: 20.03.2002
(51) Int. Cl.: G02B 5/18, G02B 27/44, G03F 7/20, G02F 1/33, H03H 9/145, G02F 1/11, G02F 1/01

(54) **Beleuchtungs- und Belichtungssytem und -verfahren**
illumination system, exposure system and exposure method
Système d'illumination et système et procédé d'exposition

(30) Priorität: 21.03.2001 DE 10113788
(43) Veröffentlichungstag der Anmeldung: 25.09.2002
(73) Patentinhaber: Carl Zeiss, 89518 Heidenheim (Brenz) (DE); Carl-Zeiss-Stiftung trading as Carl Zeiss, 89518 Heidenheim (Brenz) (DE)
(72) Erfinder: Ross-Messemer, Martin, Dr., 73457 Essingen (DE); Menck, Alexander, Dr., 73431 Aalen (DE); Höller, Frank, Dr., 73434 Aalen (DE); Franke, Kurt, Dr., 01307 Dresden (DE); Martin, Günter, Dr., 01307 Dresden (DE); Schmidt, Hagen, Dipl.-Ing., 04229 Leipzig (DE); Weihnacht, Manfred, Dr., 01744 Malter (DE)
(74) Vertreter: Schorr, Frank Jürgen

(56) Entgegenhaltungen:
- EP-A- 0 580 307
- WO-A-86/06505
- US-A- 3 684 892
- US-A- 4 370 030
- US-A- 4 635 008
- US-A- 5 744 721
- US-A- 5 831 492
- TUCOULOU R ET AL: "ONE AND TWO DIMENSIONAL SPACE SCANNINGS OF X-RAY BEAMS BY DIFFRACTION ON SURFACE ACOUSTIC WAVES: APPLICATION TO X-RAY IMAGING" REVIEW OF SCIENTIFIC INSTRUMENTS, AMERICAN INSTITUTE OF PHYSICS. NEW YORK, US, Bd. 69, Nr. 7, Juli 1998 (1998-07), Seiten 2704-2707, XP000834629 ISSN: 0034-6748
- PATENT ABSTRACTS OF JAPAN Bd. 014, Nr. 005 (E-869), 9. Januar 1990 (1990-01-09) & JP 01 252015 A (TOSHIBA CORP), 6. Oktober 1989 (1989-10-06)
- SHIGEO HAYASHI: "A VERSATILE PHOTOELASTIC-MODULATOR DRIVER/CONTROLLER" JAPANESE JOURNAL OF APPLIED PHYSICS, PUBLICATION OFFICE JAPANESE JOURNAL OF APPLIED PHYSICS. TOKYO, JP, Bd. 28, Nr. 4, 1. April 1989 (1989-04-01), Seiten 720-722, XP002025068 ISSN: 0021-4922
- [Online] Gefunden im Internet: URL:http://www.esrf.fr/info/science/annrep /95-96/report/exp/id32/id32.htm> [gefunden am 2006-01-26] * das ganze Dokument *
- TUCOULOU R. ET AL: 'Diffraction of a focused X-ray beam by surface acoustic waves' OPTICS COMMUNICATIONS Bd. 188, 15 Juli 1995, Seiten 175 - 180

## Beschreibung

Die Erfindung betrifft eine beugungsoptische Komponente zur Bereitstellung einer strahlungsbeugenden Gitterstruktur, wobei die Gitterstruktur zur Beugung und Ablenkung eines einfallenden Lichtstrahls durch Oberflächenwellen auf einer Oberfläche eines Substrats bereitstellbar ist. Eine Wellenlänge des an der Gitterstruktur zu beugenden Lichtes kann zunächst eine beliebige Wellenlänge aus dem optischen Spektrum sein. Insbesondere betrifft die Erfindung jedoch eine beugungsoptische Komponente zur Bereitstellung einer Gitterstruktur zur Beugung von Licht in den Bereichen des Ultraviolett, des extremen Ultraviolett (EUV), mit Wellenlängen von etwa 0,1nm bis etwa 100nm, sowie des Röntgenbereichs. Die Erfindung betrifft weiter ein Beleuchtungssystem mittels welchem ein Lichtstrahl, insbesondere aus den Wellenlängenbereichen Ultraviolett, extremes Ultraviolett und Röntgen, ablenkbar und steuerbar ist. Ferner betrifft die Erfindung ein Belichtungssystem zum Abbilden eines an einer Maske bereitgestellten Musters auf ein Substrat, wobei ein zur Abbildung eingesetzter Lichtstrahl durch die beugungsoptische Komponente steuerbar ist und wobei das Muster insbesondere Komponenten eines miniaturisierten Bauelements darstellt. Ferner betrifft die Erfindung ein Belichtungsverfahren zur Herstellung eines miniaturisierten Bauelements mit einem photolithographischen Schritt.

Bei der Herstellung von miniaturisierten Bauelementen, insbesondere von Halbleiter-Bauelementen, wird herkömmlicherweise ein photolithographischer Schritt eingesetzt, um auf einer Maske vorgegebene Strukturen auf ein mit einer strahlungsempfindlichen Schicht versehenes Substrat abzubilden und dabei die strahlungsempfindliche Schicht zu belichten. Eine untere Grenze von Abmessungen der abgebildeten Strukturen (CD, "critical dimension") ist dabei durch die Wellenlänge des für die Abbildung verwendeten Lichts vorgegeben. Bei immer kleiner werdenden Strukturen der herzustellenden miniaturisierten Bauelemente sind deshalb immer kürzere Wellenlängen des Lichts zur Abbildung einzusetzen. Allerdings sind für Wellenlängen unterhalb Ultraviolett abbildende optische Komponenten und Komponenten zur Strahlführung bzw. Ablenkung schwer handhabbar bzw. Technologien für solche Komponenten noch nicht ausreichend entwickelt. Beispiele für Beleuchtungsoptiken im Bereich des EUV sind aus US 5 973 826, 6 033 079 und US 6 142 641 bekannt.

Aus ESRF, "Annual Report, 1995/1996:ID32" in http://www.esrf.fr/info/science/annrep/95-
96/report/exp/id32/id32.htm (29.01.2001) ist ein Röntgenstrahlchopper bekannt, welcher Röntgenstrahlung durch ein schaltbares optisches Gitter schaltet, welches durch Oberflächenwellen (SAW, SURFACE ACOUSTIC WAVES ) bereitgestellt ist. Allerdings ist bei dieser bekannten Anordnung eine Beugungsintensität des SAW-Gitters und damit eine Intensität des schaltbaren Strahls zu gering, als daß sich die dort beschriebene Oberflächenwellen-Bauanordnung zum wirtschaftlichen Einsatz in Lithographieverfahren eignen würde.

Die US 4,370,030 offenbart einen Lichtmodulator, welcher unter Einsatz akkustischer Oberflächenwellen arbeitet, wobei der beleuchtende Strahl die aktive Oberfläche eines transparenten elektrooptischen akkustischen Substrats unter einem Winkel in der Nähe des Einfallsglanzwinkels trifft und von jener Oberfläche durch den verbleibenden Abschnitt des Substrats reflektiert wird, und zwar auf dessen andere Seite in der 0.- oder 1.-Beugungsordnung. Das Licht wird so gerichtet, dass es mit der akustischen Welle so stark wie möglich wechselwirkt.

R. Tucoulou et al in Review of scientific Instruments, 69(7), 2704-2707, 1998 zeigt ein Beleuchtungssystem, das die Merkmale des Oberbegriffs des Anspruchs 1 enthält.

Es ist eine Aufgabe der vorliegenden Erfindung, ein Beleuchtungssystem mit einer beugungsoptischen Komponente zur Bereitstellung einer strahlungsbeugenden Gitterstruktur vorzuschlagen, welche bei insbesondere kurzen Lichtwellenlängen eine effiziente Strahlsteuerung und Strahlablenkung ermöglicht. Ferner ist es eine Aufgabe der Erfindung ein Beleuchtungssystem mit einer beugungsoptischen Komponente zur Bereitstellung einer strahlungsbeugenden Gitterstruktur mit hoher Beugungseffizienz bei kurzen optischen Wellenlängen vorzuschlagen.

Eine Aufgabe der Erfindung ist es weiter, ein Belichtungssystem vorzuschlagen, welches sich zur Abbildung vergleichsweise kleiner Muster eignet. Insbesondere ist es eine Aufgabe der Erfindung, ein solches Belichtungssystem vorzuschlagen, welches eine vergleichsweise hohe numerische Apertur aufweist.

Weiter ist es noch eine Aufgabe der Erfindung ein Verfahren zur Herstellung eines Bauelements vorzuschlagen, welches insbesondere zur Herstellung von Bauelementen mit kleinen Strukturen geeignet ist.

Die Aufgaben werden durch ein Beleuchtungssystem nach Anspruch 1, ein Beleuchtungssystem nach Anspruch 27 sowie ein Verfahren nach Anspruch 28 gelöst.

Die Erfindung geht aus von einer beugungsoptischen Komponente zur Bereitstellung einer strahlungsbeugenden Gitterstruktur, welche eine Oberflächenwellen-Bauanordnung umfaßt, die ein Substrat, eine Oberflächenwellenquelle zur Erzeugung von Oberflächenwellen auf einer Oberfläche des Substrats und einen Wechselwirkungsbereich der Substratoberfläche aufweist, der für eine Wechselwirkung der Strahlung mit einer Gitterstruktur vorgesehen ist, welche durch die erzeugten Oberflächenwellen bereitgestellt ist.

Unter einem ersten Aspekt liegt der Erfindung die Erkenntnis zugrunde, daß durch die SAW-Gitterstruktur dann eine hohe Beugungseffizienz bereitgestellt werden kann, wenn die SAW-Gitterstruktur ein qualitativ hochwertiges Beugungsgitter erzeugt, welches im Idealfall durch Wellenzüge von Oberflächenwellen gebildet ist, deren Profile im gesamten Wechselwirkungsbereich gleiche, vorzugsweise im wesentlichen sinusähnliche oder sinusförmige Gestalt aufweisen. In dieser Hinsicht wurde festgestellt, daß die Oberflächenwellenquelle der herkömmlichen beugungsoptischen Komponente neben Oberflächenwellen, die hin zu dem Wechselwirkungsbereich emittiert werden, auch Oberflächenwellen emittiert, die nicht zu dem Wechselwirkungsbereich gerichtet sind. Diese eigentlich von dem Wechselwirkungsbereich weg gerichteten Oberflächenwellen werden allerdings an Rändern des Substrats reflektiert und gelangen gegebenenfalls über Umwege schließlich doch in den Wechselwirkungsbereich, wo sie die Profile der direkt von der Oberflächenwellenquelle zu dem Wechselwirkungsbereich hin emittierten Oberflächenwellen stören und damit schließlich die Qualität des optischen Gitters senken.

Im Hinblick auf eine Reduzierung derartiger über Umwege unerwünscht in den Wechselwirkungsbereich gelangender Oberflächenwellen wurde bereits vorgeschlagen, in Ausbreitungswegen von Oberflächenwellen, die nicht direkt zum Wechselwirkungsbereich gerichtet sind, Oberflächenwellendämpfer aus elastischem Material auf das Substrat aufzubringen. Allerdings ist auch die Dämpfungseffizienz derartiger bekannter Dämpfer nicht immer ausreichend.

Unter dem ersten Aspekt liegt der Erfindung nun die Idee zugrunde, Oberflächenwellen, die nicht hin zu dem Wechselwirkungsbereich emittiert werden, auf dem Substrat gar nicht erst zu erzeugen.

Hierzu schlägt die Erfindung vor, als Oberflächenwellenquelle eine unidirektionale Quelle, d.h. eine Oberflächenquelle mit einer Richtcharakteristik vorzusehen, welche Oberflächenwellen in eine Vorzugsrichtung stärker emittiert als in eine hierzu entgegengesetzte Richtung, und dabei die Oberflächenwellenquelle relativ zu dem Wechselwirkungsbereich derart anzuordnen, daß die in die Vorzugsrichtung emittierten Oberflächenwellen den Wechselwirkungsbereich, gegebenenfalls auch nach Ablenkung mittels Oberflächenwellenspiegeln oder ähnlichem, durchlaufen.

Durch den Einsatz einer solchen unidirektionalen Oberflächenwellenquelle wird somit die Entstehung von unerwünschten Oberflächenwellen vermieden, welche nicht wie gewünscht auf den Wechselwirkungsbereich gerichtet sind und indirekt und unerwünscht in diesen reflektiert werden könnten.

Unter einem weiteren Aspekt liegt der Erfindung der Gedanke zugrunde, daß im Hinblick auf eine Steuerung und Änderung des Ablenk- bzw. Beugungswinkels zwischen einfallendem und ausfallendem Strahl eine Gitterkonstante der Gitterstruktur änderbar sein muß. Hierzu ist die herkömmliche beugungsoptische Komponente jedoch nur in sehr beschränktem Umfang in der Lage. Der Erfindung liegt demgemäß die Idee zugrunde, in der Oberflächenwellen-Bauanordnung eine Oberflächenwellenquelle einzusetzen, welche zur Emission von Oberflächenwellen bei mehreren voneinander verschiedenen Wellenlängen ausgelegt ist.

Die Erfindung zeichnet sich unter diesem Aspekt dadurch aus, daß die Oberflächenwellenquelle einen elektroakustischen Wandler mit einer Elektrodenstruktur umfaßt, welche ein Vielzahl von Teilelektroden aufweist, die mit Abstand zu benachbarten Teilelektroden angeordnet sind. Hierbei ist in der Elektrodenstruktur eine Mehrzahl von Bereichen vorgesehen, welche in Emissionsrichtung der Oberflächenwellen nebeneinander und mit Abstand voneinander angeordnet sind und wobei in einem jeden der Bereiche die Teilelektroden periodisch angeordnet sind. Die verschiedenen Bereiche unterscheiden sich dadurch voneinander, daß die Anordnungsperioden der Teilelektroden in den jeweiligen Bereichen voneinander verschieden sind.

Da die Anordnungsperiode von Teilelektroden eines Bereichs die Wellenlänge festlegt, bei der dieser Bereich Oberflächenwellen mit erhöhter Effizienz emittiert, ist durch die Bereitstellung der Bereiche mit unterschiedlichen Anordnungsperioden insgesamt eine Oberflächenwellenquelle geschaffen, welche in einem vergleichsweise breiten Wellenlängenbereich Oberflächenwellen mit verhältnismäßig hoher Effizienz emittieren kann.

Unter einem weiteren Aspekt geht die Erfindung von dem Gedanken aus, daß zur Erzielung einer hohen Beugungseffizienz ein Oberflächenwellengitter mit hoher Oberflächenwellenamplitude bereitzustellen ist. Bei einer Oberflächenquelle mit elektroakustischem Wandler kann die Amplitude der emittierten Oberflächenwellen dadurch erhöht werden, daß an Elektroden des elektroakustischen Wandlers Wechselspannungen mit höherer Spannungsamplitude angelegt werden. Allerdings sind einer an den elektroakustischen Wandler maximal anlegbaren Spannungsamplitude in der Praxis durch elektrische Überschläge zwischen Elektroden und Teilelektroden des Wandlers Grenzen gesetzt.

Der Erfindung liegt unter diesem Aspekt die Idee zugrunde, einen elektroakustischen Wandler einzusetzen, welcher bei Anlegen einer vergleichsweise niedrigen Spannung bereits Oberflächenwellen mit hoher Amplitude erzeugt.

Unter diesem Aspekt zeichnet sich die Erfindung dadurch aus, daß der elektroakustische Wandler zwei Gruppen von Fingerelektroden aufweist, wobei die Fingerelektroden einer jeden Gruppe elektrisch leitend miteinander verbunden und die Fingerelektroden unterschiedlicher Gruppen elektrisch voneinander isoliert sind. An diese Gruppen von Fingerelektroden wird die elektrische Antriebswechselspannung im Betrieb des elektroakustischen Wandlers angelegt. Zwischen Paaren von Fingerelektroden unterschiedlicher Gruppen ist wenigstens eine von den Fingerelektroden der beiden Gruppen jeweils elektrisch isolierte Zwischenelektrode vorgesehen. Das elektrische Potential dieser Zwischenelektrode ist vorzugsweise sich frei einstellend (floating), so daß über die Komponenten Fingerelektrode der ersten Gruppe, Zwischenelektrode und Fingerelektrode der anderen Gruppe gewissermaßen ein Spannungsteiler bereitgestellt ist, bei welchem eine zwischen zwei benachbarten Elektroden auftretende elektrische Spannung geringer ist als die insgesamt zwischen den Gruppen von Fingerelektroden anliegende Spannung. Durch diese Maßnahme wird die Neigung zu Überschlägen zwischen Elektroden des elektroakustischen Wandlers wirksam reduziert, wobei gleichwohl von dem elektroakustischen Wandler Oberflächenwellen hoher Amplitude emittiert werden können.

Vorzugsweise weist auch die Zwischenelektrode, ebenso wie die Fingerelektroden, eine periodische Struktur auf, wobei von der Zwischenelektrode Zweigelektroden ausgehen, welche sich zwischen benachbarten Fingerelektroden erstrecken.

Bei dieser ineinandergreifenden Struktur von Fingerelektroden und Zweigelektroden ist es im Hinblick auf die Wirkung der Gesamtelektrodenstruktur als Spannungsteiler vorteilhaft, daß sich die Fingerelektroden verschiedener Gruppen zueinander parallel versetzt, allerdings vorzugsweise nicht auf einer gemeinsamen Geraden erstrecken. Hierbei ist es ebenfalls vorteilhaft, wenn Fingerelektroden und Zweigelektroden einander paarweise zugeordnet sind und die einander zugeordneten Zweig- bzw. Fingerelektroden sich in etwa auf jeweils gemeinsamen Geraden erstrecken.

Unter einem weiteren Aspekt liegt der Erfindung wiederum die Erkenntnis zugrunde, daß zur Erzielung einer hohen Beugungseffizienz eine hohe Amplitude der die strahlungsbeugende Gitterstruktur bereitstellenden Oberflächenwellen notwendig ist. Hierbei liegt der Erfindung die Idee zugrunde, eine Frequenz zur Erregung der Oberflächenwellequelle so einzustellen, daß die Amplitude der von der Oberflächenquelle emittierten Oberflächenwellen im wesentlichen maximal ist.

Unter diesem Aspekt zeichnet sich die Erfindung dadurch aus, daß auf dem Substrat ein Oberflächenwellenempfänger für von der Oberflächenwellenquelle emittierte Oberflächenwellen vorgesehen ist, der ein Meßsignal bereitstellt, welches eine Amplitude der Oberflächenwellen repräsentiert, die auf den Oberflächenwellenempfänger treffen. Es ist dann weiter eine Steuerung vorgesehen, welche die Frequenz zur Erregung der Oberflächenwellenquelle in Abhängigkeit von dem Meßsignal des Oberflächenwellenempfängers einstellt.

Hierdurch ist eine Anordnung bereitgestellt, die es erlaubt, die Frequenz zur Erregung der Oberflächenwellenquelle so lange, gegebenenfalls iterativ, abzuändern, bis die Amplitude der empfangenen Oberflächenwellen im wesentlichen maximal ist. Es kann dann davon ausgegangen werden, daß auch die Oberflächenwellenquelle Oberflächenwellen mit maximaler Amplitude emittiert und daß dann ferner auch die Gitterstruktur in dem Wechselwirkungsbereich durch Oberflächenwellen maximaler Amplitude bereitgestellt ist.

Eine im Hinblick auf die Emission von Oberflächenwellen mit möglichst hoher Amplitude ausgelegte Oberflächenwellenquelle weist typischerweise in Abhängigkeit von der Erregungsfrequenz einen Verlauf der Amplitude der emittierten Oberflächenwellen derart auf, daß bei einer Zentralfrequenz die Amplitude der erzeugten Oberflächenwellen maximal ist und beidseits der Zentralfrequenz die Amplitude mit einer charakteristischen Frequenzbreite abnimmt. Ebenso weist typischerweise ein Oberflächenwellenempfänger bei gleichbleibender Amplitude der empfangenen Oberflächenwellen in Abhängigkeit von der Oberflächenwellenfrequenz einen Verlauf des Meßsignals auf, der ebenfalls beidseits einer Zentralfrequenz mit einer charakteristischen Frequenzbreite abfällt.

Vorzugsweise sind die Oberflächenwellenquellen und der Oberflächenwellenempfänger derart aufeinander abgestimmt, daß die charakteristische Frequenzbreite der Oberflächenwellenquelle kleiner ist als die typische Frequenzbreite des Oberflächenwellenempfängers. Hierdurch ist es möglich, zum einen die Oberflächenquelle im Hinblick auf die Emission hoher Amplituden zu optimieren und zum anderen einen Empfänger bereitzustellen, der bei verschiedenen Mittelfrequenzen der Oberflächenwellenquelle mit guter Effizienz Oberflächenwellen empfangen kann. Diese Auslegung ist insbesondere unter dem Gesichtspunkt vorteilhaft, daß die Mittelfrequenz an der Oberflächenwellenquelle aufgrund beispielsweise von Temperaturdriften zeitlich nicht konstant sein muß oder die Oberflächenwellenquelle zur Änderung des Ablenk- bzw. Beugungswinkels gezielt mit sich ändernden Frequenzen angesteuert wird. Es ist dann möglich, die Frequenz zur Erregung der Oberflächenwellenquelle in Abhängigkeit von alleine dem Meßsignal des Oberflächenwellenempfängers einzustellen, um im wesentlichen die maximal mögliche Oberflächenwellenamplitude zu erreichen.

Im Hinblick auf eine noch genauere Einstellung der Frequenz zur Erzeugung der maximal möglichen Oberflächenwellenamplitude wird die Frequenz neben der Abhängigkeit von dem Meßsignal auch noch in Abhängigkeit von dem Verlauf des Meßsignals in Abhängigkeit von der Frequenz gesteuert. Dadurch wird auch der Abhängigkeit des Meßsignals von der Frequenz Rechnung getragen und eine noch genauere Frequenzeinstellung ermöglicht.

Unter einem weiteren Aspekt geht die Erfindung wiederum davon aus, daß zur Erreichung einer hohen Beugungseffizienz eine Gitterstruktur mit hoher Gitterqualität notwendig ist. Unter diesem Aspekt liegt der Erfindung die Erkenntnis zugrunde, daß Oberflächenwellen, welche von der Oberflächenwellenquelle emittiert wurden, nach Durchlaufen des Wechselwirkungsbereichs auf dem Substrat weiter propagieren, bis sie schließlich auf einen Substratrand treffen und von diesem, gegebenenfalls über Umwege, zurück in den Wechselwirkungsbereich reflektiert werden und dort die Profile der eigentlich gewünschten Gitterstruktur stören.

Unter diesem Aspekt schlägt die Erfindung vor, die Oberflächenwellen nach Durchlaufen des Wechselwirkungsbereichs durch einen Oberflächenwellendämpfer zu dämpfen, so daß eine Intensität an in den Wechselwirkungsbereich zurückreflektierten Oberflächenwellen möglichst gering ist.

Ein solcher Oberflächenwellendämpfer kann beispielsweise aus elastomerem Material gebildet sein, welches auf das Substrat aufgebracht ist und in welchem die mechanische Energie der Oberflächenwellen in thermische Energie dissipiert wird. Ein Nachteil eines solchen Oberflächenwellendämpfers liegt darin, daß er Wärme auf dem Substrat erzeugt, was zu einer Änderung der Ausbreitungseigenschaften der Oberflächenwellen auf dem Substrat führt.

Gemäß einer bevorzugten Ausführungsform der Erfindung ist deshalb vorgesehen, daß der Oberflächenwellendämpfer als akustoelektrischer Wandler ausgebildet ist, um die mechanische Energie der Oberflächenwellen am Ort des Oberflächenwellendämpfers in elektrische Energie umzuwandeln. Die elektrische Energie kann dann insbesondere ohne thermische Belastung des Substrats von diesem weg transportiert und an von dem Substrat entfernter Stelle in geeigneter Weise dissipiert werden, so daß eine thermische Belastung des Substrats durch den Oberflächenwellendämpfer vergleichsweise gering ist.

Hierzu weist der akustoelektrische Wandler vorzugsweise wenigstens zwei elektrische Anschlüsse auf, an denen die erzeugte elektrische Energie abgegriffen werden kann, indem daran eine Widerstandsschaltung angeschlossen wird, um die abgegriffene elektrische Energie in der Widerstandsschaltung zu dissipieren.

Um die mechanische Energie der Oberflächenwellen mit möglichst hoher Effizienz in elektrische Energie umzuwandeln und diese möglichst vollständig abzugreifen und zu dissipieren, sind elektrische Impedanzen des elektroakustischen Wandlers und der Widerstandsschaltung vorzugsweise derart aufeinander abgestimmt, daß sie zueinander konjugiert komplexe Werte aufweisen.

Vorzugsweise sind die Strukturen des elektroakustischen Wandlers der Oberflächenwellenquelle und des akustoelektrischen Wandlers des Oberflächenwellendämpfers zueinander symmetrisch, insbesondere mit symmetrischer Ausgestaltung von Teilelektroden, ausgebildet.

Da allerdings die von der Oberflächenwellenquelle emittierten Oberflächenwellen auf ihrem Weg zu dem Oberflächenwellendämpfer an Amplitude bzw. Energie verlieren und auch die Oberflächenwellenquelle nicht die gesamte zugeführte elektrische Energie in Oberflächenwellen umwandelt, ist auch bei idealer Symmetrie zwischen Oberflächenwellenquelle und Oberflächenwellendämpfer davon auszugehen, daß das Substrat im Bereich der Oberflächenwellenquelle eine höhere Betriebstemperatur aufweist als das Substrat im Bereich des Oberflächenwellendämpfers. Da sowohl die Ausbreitungsgeschwindigkeit der Oberflächenwellen als auch der Abstand von Teilelektroden des elektroakustischen Wandlers oder des akustoelektrischen Wandlers von der Temperatur abhängig sind, folgt dann weiter, daß die ursprünglich symmetrisch aufeinander abgestimmten komponenten Oberflächenwellenquelle und Oberflächenwellenempfänger aufgrund eines Temperaturunterschieds nicht mehr ideal aufeinander abgestimmt sind. Ferner ist es auch bei unterschiedlicher Gestaltung der Oberflächenwellenquelle und des Oberflächenwellenempfängers sowie durch ein thermisches Eingreifen, wie beispielsweise Kühlen von Bereichen des Substrats, möglich, daß Temperaturunterschiede zwischen Oberflächenwellenquelle und Oberflächenwellenempfänger erzeugt werden, wobei auch der Oberflächenwellenempfänger eine höhere Temperatur als die Oberflächenwellenquelle aufweisen kann. Auch dann wird eine ursprünglich, d.h. bei gleicher Temperatur der Komponenten, ideale Auslegung und Abstimmung der Komponenten Oberflächenwellenquelle und Oberflächenwellenempfänger gestört.

Demgemäß sieht die Erfindung vor, unterschiedlichen Betriebstemperaturen von Oberflächenwellenquelle und Oberflächenwellenempfänger dadurch Rechnung zu tragen, daß Anordnungsperioden von Teilelektroden des elektroakustischen Wandlers der Oberflächenwellenquelle und des akustoelektrischen Wandlers des Oberflächenwellendämpfers voneinander verschieden sind, wobei der Unterschied der Anordnungsperioden auf die Unterschiede in den zu erwartenden Betriebstemperaturen der Komponenten abgestimmt sind.

Vorzugsweise unterscheiden sich die Anordnungsperioden des elektroakustischen Wandlers und des akustoelektrischen Wandlers voneinander in Bereichen von etwa 0,01% bis etwa 0,5%, vorzugsweise von etwa 0,01% bis etwa 0,05%, weiter bevorzugt von etwa 0,05% bis 0,15% und ebenfalls bevorzugt von etwa 0,15% bis etwa 0,5%.

Vorzugsweise weist der Oberflächenwellendämpfer eine Richtcharakteristik dahingehend auf, daß er Oberflächenwellen, die aus einer Vorzugsrichtung auf den Oberflächenwellendämpfer treffen, stärker gedämpft werden als Oberflächenwellen, welche aus einer hierzu entgegengesetzten Richtung auf den Oberflächenwellendämpfer treffen. Der Vorteil einer solchen Unidirektionalität des Oberflächenwellendämpfers kann verstanden werden, wenn man berücksichtigt, daß ein akustoelektrischer Wandler und ein elektroakustischer Wandler grundsätzlich gleiche oder ähnliche Elektrodenstrukturen aufweisen können. Ein unidirektionaler elektroakustischer Wandler strahlt Oberflächenwellen mit erhöhter Effizienz in eine Vorzugsrichtung ab. Entsprechend ist es verständlich, daß Oberflächenwellen, welche aus lediglich einer Richtung auf einen akustoelektrischen Wandler treffen, dann mit besonders guter Effizienz absorbiert werden, wenn der akustoelektrische Wandler eine Elektrodenstruktur aufweist, die der eines unidirektionalen elektroakustischen Wandlers entspricht.

Vorzugsweise wird der Oberflächenwellendämpfer derart angeordnet, daß Oberflächenwellen, die den Wechselwirkungsbereich durchlaufen haben und dort als optisches Gitter gewirkt haben, von dem Oberflächenwellendämpfer gedämpft werden, um eine thermische Belastung des Substrats zu reduzieren und um ebenfalls zu vermeiden, daß diese Oberflächenwellen nach Reflexion etwa an Substraträndern wieder zurück in den Wechselwirkungsbereich gelangen.

Vorzugsweise wird der Oberflächenwellendämpfer allerdings auch dazu eingesetzt, Oberflächenwellen zu absorbieren, welche von der Oberflächenwellenquelle nicht in Richtung zu dem Wechselwirkungsbereich emittiert werden.

Unter noch einem weiteren Aspekt geht die Erfindung wiederum davon aus, daß zur Erzielung einer möglichst hohen Beugungseffizienz auch hohe Amplituden der Oberflächenwellen notwendig sind. Der Erfindung liegt unter diesem Aspekt die Idee zugrunde, Oberflächenwellen, die den Wechselwirkungsbereich durchlaufen haben, nicht etwa in einem Oberflächenwellendämpfer zu vernichten, sondern diese erneut dem Wechselwirkungsbereich zuzuführen.

Die Erfindung zeichnet sich unter diesem Aspekt dadurch aus, daß auf dem Substrat eine Mehrzahl von Spiegeln für Oberflächenwellen derart angeordnet ist, daß die Spiegel einen geschlossenen Ausbreitungsweg für die Oberflächenwellen bereitstellen und der Wechselwirkungsbereich in diesem geschlossenen Ausbreitungsweg liegt. Es wird dadurch Oberflächenwellenenergie nach Durchlaufen des Wechselwirkungsbereichs über den geschlossenen Ausbreitungsweg wieder in den Wechselwirkungsbereich zurückgeführt, um dort zu einer Erhöhung der Oberflächenwellenamplitude beizutragen.

Vorzugsweise liegt ebenfalls die Oberflächenwellenquelle in dem geschlossenen Ausbreitungsweg, wobei allerdings die Oberflächenwellenquelle eine Richtcharakteristik aufweist und Oberflächenwellen in eine Vorzugsrichtung stärker emittiert als in eine hierzu entgegengesetzte Richtung. Die Vorzugsrichtung der Oberflächenwellenquelle legt dadurch die Umlaufrichtung der Oberflächenwellen in dem geschlossenen Ausbreitungsweg fest.

Alternativ hierzu ist es ebenfalls bevorzugt, die Oberflächenwellenquelle außerhalb des geschlossenen Ausbreitungswegs anzuordnen und die von dieser emittierten Oberflächenwellen in den geschlossenen Ausbreitungsweg einzukoppeln. Diese Ausbildung hat den Vorteil, daß die Oberflächenwellenquelle selbst nicht der höchsten Amplitude an Oberflächenwellen ausgesetzt ist und damit die Oberflächenwellenquelle eine vergleichsweise längere Standzeit aufweist, da Effekte wie Materialmigration in den Strukturen der Oberflächenwellenquelle reduziert sind.

Die Einkoppelung der von der Oberflächenwellenquelle emittierten Oberflächenwellen in den geschlossenen Ausbreitungsweg erfolgt vorzugsweise mittels eines Spiegels, der die einzukoppelnden Oberflächenwellen in den geschlossenen Ausbreitungsweg reflektiert und der für Oberflächenwellen, die entlang dem geschlossenen Ausbreitungsweg propagieren, transparent ist.

Ferner ist es vorteilhaft, Spiegel auf dem Substrat derart anzuordnen, daß Oberflächenwellen, die den Wechselwirkungsbereich in eine Richtung durchlaufen haben, so umgelenkt werden, daß sie den Wechselwirkungsbereich nochmals in einer anderen Richtung durchlaufen. Hierdurch wird ein optisches Gitter erzeugt, welches die darauffallende Strahlung nicht nur in eine Raumrichtung sondern in mehrere Raumrichtungen beugen bzw. ablenken kann.

Unter einem weiteren Aspekt liegt der Erfindung wiederum der Gedanke zugrunde, daß zur Erzielung einer hohen Beugungseffizienz ein Gitter mit hohen Gitteramplituden vorteilhaft einzusetzen ist.

Unter diesem Aspekt zeichnet sich die Erfindung dadurch aus, daß die strahlungsbeugende Gitterstruktur in dem Wechselwirkungsbereich auf dem Substrat durch stehende Oberflächenwellen bereitgestellt ist. Dies kann beispielsweise dadurch erreicht werden, daß auf dem Substrat mittels Oberflächenwellenspiegel oder anderer Ablenkelemente für Oberflächenwellen ein Oberflächenwellenresonator aufgebaut wird, d.h. eine Struktur, in der sich Oberflächenwellen resonant überlagern können, und damit eine Amplitudenerhöhung der in dem Resonator umlaufenden Wellen erzielt werden kann.

Gemäß einer vorteilhaften Ausgestaltung ist vorgesehen, daß die Oberflächenwellen, welche den Wechselwirkungsbereich durchlaufen haben, durch einen oder mehrere Spiegel wieder im wesentlichen phasenrichtig in den Wechselwirkungsbereich zurückreflektiert werden, wobei insbesondere die Ausbreitungswege der Oberflächenwellen unmittelbar nach ihrem Durchlaufen des Wechselwirkungsbereichs und nach der Reflexion zurück zum Wechselwirkungsbereich zusammenfallen können und sich nur in ihrer Richtung unterscheiden.

Im Hinblick auf einen einfachen Aufbau und eine einfache Einkopplung der von der Oberflächenwellenquelle emittierten Oberflächenwellen in den Resonator ist die Oberflächenwellenquelle selbst innerhalb des Resonators angeordnet.

Es ist allerdings ebenfalls bevorzugt, daß die Oberflächenwellenquelle außerhalb des Resonators und damit außerhalb des Ausbreitungswegs der Oberflächenwellen in dem Resonator angeordnet ist und daß die von der Oberflächenwellenquelle außerhalb des Resonators emittierten Oberflächenwellen in den Resonator eingekoppelt werden. Dies hat den Vorteil, daß die Oberflächenwellenquelle selbst nicht den hohen Oberflächenwellenamplituden in dem Resonator ausgesetzt ist, was zu höheren Standzeiten der Oberflächenwellenquelle führen kann.

Die Einkopplung der Oberflächenwellen in den Resonator bei außerhalb des Resonators angeordneter Oberflächenwellenquelle erfolgt vorzugsweise über einen Oberflächenwellenspiegel.

Die vorangehend erläuterte beugungsoptische Komponente wird mit einer durch Oberflächenwellen bereitgestellten Gitterstruktur in einem Beleuchtungssystem eingesetzt, welches neben der beugungsoptischen Komponente noch eine Strahlungsquelle umfaßt, deren Strahlung auf den Wechselwirkungsbereich der Oberflächenwellen-Bauanordnung gerichtet ist. Die auf den Wechselwirkungsbereich fallende Strahlung der Strahlungsquelle wird an der Gitterstruktur gebeugt bzw. abgelenkt, wobei durch Ändern einer Betriebsweise der Oberflächenwellen-Bauanordnung die Gitterstruktur änderbar ist und damit Beugungswinkel bzw. Ablenkwinkel gezielt änderbar sind.

Unter einer Strahlungsquelle ist hierbei eine Strahlungsquelle jeglicher Art zu verstehen, welche ihre Strahlung unmittelbar oder indirekt, d.h. nach ein oder mehreren Reflexionen oder unter Zwischenschaltung abbildender optischer Elemente usw., auf den Wechselwirkungsbereich richtet. Ebenfalls sind hierunter sogenannte virtuelle Strahlungsquellen zu verstehen, welche für den Wechselwirkungsbereich sichtbar sind und deren Licht auf den Wechselwirkungsbereich fällt.

Die Strahlungsquelle emittiert die auf den Wechselwirkungsbereich gerichtete Strahlung vorzugsweise kontinuierlich, was insbesondere bei Ausführungen, bei denen die Oberflächenwellen in dem Wechselwirkungsbereich kontinuierlich propagieren, ausgenutzt werden kann, um einen abgelenkten Strahl mit gleichbleibender Intensität zu erzeugen.

Es ist ebenfalls vorgesehen, Oberflächenwellen als Pulse bzw. in Ausbreitungsrichtung räumlich begrenzte Wellenzüge durch den Wechselwirkungsbereich zu schicken, so daß insbesondere ein abgelenkter Strahl einfach schaltbar ist.

In der Situation, in der in dem Wechselwirkungsbereich stehende Wellen erzeugt werden, sieht ein kontinuierlich auf den Wechselwirkungsbereich fallender Strahl zeitlich alternierend ein Gitter mit abwechselnd hoher und niedriger Gitteramplitude, wobei es ebenfalls Zeitpunkte gibt, an denen die Gitteramplitude im wesentlichen Null ist. Dies führt dazu, daß die Intensität eines abgelenkten bzw. gebeugten Strahls ebenfalls zeitlich moduliert wird und Werte zwischen Null und einer maximalen Intensität annimmt.

Um hauptsächlich abgelenkte bzw. gebeugte Strahlung mit im wesentlichen maximaler Beugungsintensität mit stehenden Oberflächenwellen zu erzeugen, ist vorzugsweise vorgesehen, daß die Strahlungsquelle des Beleuchtungssystemes eine gepulste Strahlungsquelle ist, d.h. eine Strahlungsquelle, welche ihre Strahlung nicht mit zeitlich konstanter Intensität emittiert. Es ist dann weiter vorgesehen, die Strahlungsquelle mit der die stehenden Oberflächenwellen erzeugenden Oberflächenwellen-Bauanordnung derart zu synchronisieren, daß zu Zeitpunkten bzw. in Zeiträumen, bei denen die von der Strahlungsquelle emittierte Intensität einen vergleichsweise hohen Wert aufweist, ebenfalls die Amplituden der stehenden Oberflächenwellen einen vergleichsweise hohen Wert einnehmen. Dies bedeutet, daß die Strahlungspulse immer dann auf die Gitterstruktur treffen, wenn diese auch ihre im wesentlichen maximale Gitteramplitude aufweist.

Als gepulste Strahlungsquelle sind bevorzugterweise vorgesehen: Eine kontinuierliche Strahlungsquelle, die mit einem zeitlich variierten Verschluß, beispielsweise einem Chopperrad, kombiniert ist, und eine intrinsisch gepulste Strahlungsquelle, wie etwa ein Pulsfolgen emittierender Laser oder auch ein Synchrotron, dessen geladene Teilchen als Teilchenpakete in dem Speicherring umlaufen.

Zur Synchronisierung der Strahlungsquelle mit der Oberflächenwellen-Bauanordnung ist vorteilhafterweise eine Steuerung vorgesehen, mittels der eine Frequenz und eine Phasenlage der erzeugten Oberflächenwellen einstellbar ist, wobei die Ansteuervorrichtung auf ein Signal anspricht, welches die Pulsfolge der Strahlungsquelle oder eine Folge von Teilpulsen der Strahlungsquelle repräsentiert. Es werden dann durch die Steuerung die Zeitpunkte, an denen die erzeugte Gitterstruktur große Gitteramplituden aufweist, an die Zeitpunkte angepaßt, an denen ebenfalls die Intensität der von der Strahlungsquelle emittierten Strahlung hoch ist.

Alternativ oder ergänzend hierzu ist es ebenfalls bevorzugt, eine Steuerung vorzusehen, die die Frequenz und Phasenlage der von der Strahlungsquelle emittierten Pulse an die Amplituden der Gitterstruktur anpassen. Es wird in diesem Fall die Strahlungsquelle im Verhältnis zu der Oberflächenwellen-Bauanordnung synchronisiert.

Eine vorteilhafte Anwendung des Beleuchtungssystemes liegt in der Belichtung eines Substrats mit Mustern bzw. Bildern, d.h. mit einer ortsabhängigen Strahlungsintensität. Hierzu wird das Muster, mit dem das Substrat belichtet werden soll, vorzugsweise durch eine Maske bereitgestellt, und das Beleuchtungssystem ist durch ein abbildendes System ergänzt, welches die Maske auf das Substrat abbildet.

Das hierdurch gebildete Belichtungssystem umfaßt vorzugsweise einen Substrathalter und einen Maskenhalter, an denen ein zu belichtendes Substrat bzw. eine das abzubildende Muster vorgebende Maske derart anbringbar sind, daß deren wirksame Flächen in einer vorbestimmten Substratebene bzw. Maskenebene des Beleuchtungssystemes angeordnet sind. Ferner ist ein Kondensor vorgesehen, der Licht der Strahlungsquelle, welches an der Gitterstruktur in unterschiedliche Raumrichtungen gebeugt wurde, fokussierend auf die Maske richtet. Die in unterschiedliche Richtungen an der Gitterstruktur gebeugte Strahlung kann dabei Strahlung sein, die zu einem Zeitpunkt beispielsweise in unterschiedliche Beugungsordnungen, d.h. unterschiedliche Beugungswinkel, gebeugt wurde, und es kann sich auch um Strahlung handeln, die zeitlich nacheinander mit unterschiedlichem Ablenk- bzw. Beugungswinkel abgelenkt wurde. Dies kann beispielsweise dadurch geschehen, daß eine Gitterperiode der Gitterstruktur zeitlich geändert wird, indem die Oberflächenwellen-Bauanordnung zeitabhängig mit unterschiedlichen Frequenzen angeregt wird.

Es ist also mit der beschriebenen Anordnung aus Strahlungsquelle, beugungsoptischer Komponente, Kondensor und Maskenhalter bzw. der entsprechenden Maskenoberfläche möglich, die Maskenoberfläche entweder zeitgleich oder zeitlich nacheinander mit Strahlung zu beleuchten, welche unter unterschiedlichen Einfallswinkeln auf die Maskenoberfläche fällt. Es entsteht somit zur Belichtung der Maskenoberfläche ein Beleuchtungssystem mit vergleichsweise hoher numerischer Apertur.

Zur Abbildung der Maskenoberfläche auf die Substratoberfläche ist dann vorteilhafterweise weiter ein Objektiv vorgesehen, welches bezüglich des Maskenhalters und des Substrathalters derart angeordnet ist, daß die Strahlung, die aufgrund der unterschiedlichen Einfallswinkel auf die Maskenoberfläche ebenfalls unter unterschiedlichen Winkeln von der Maskenoberfläche reflektiert wird, wiederum fokussierend auf die Substratoberfläche gerichtet ist. Somit wird auch die Substratoberfläche mit hoher numerischer Apertur belichtet, und insgesamt ist ein Abbildungssystem zwischen Maske und Substrat geschaffen, welches eine Abbildung mit hoher numerischer Apertur erlaubt und damit im Hinblick auf eine Verringerung der Größe der abzubildenden Strukturen gut geeignet ist.

Ausführungsformen der Erfindung werden nachfolgend anhand von Zeichnungen näher erläutert. Hierbei zeigt:
- Figur 1: eine Ausführungsform eines erfindungsgemäßen Belichtungssystemes,
- Figur 2: eine Ausführungsform einer erfindungsgemäßen beugungsoptischen Komponente,
- Figur 3: eine schematische Auslegung einer Oberflächenwellenquelle zum Einsatz in der beugungsoptischen Komponente der Fig. 2,
- Figur 4: eine Detaildarstellung der Oberflächenwellenquelle der Fig. 3,
- Figur 5: schematische Graphen zur Erläuterung von Frequenzabhängigkeiten von Teilkomponenten der beugungsoptischen Komponente der Fig. 2,
- Figuren 6, 7, 8, 9, 10 und 12: weitere Ausführungsformen der erfindungsgemäßen beugungsoptischen Komponente und
- Figur 13: eine weitere Ausführungsform des erfindungsgemäßen Beleuchtungssystemes.

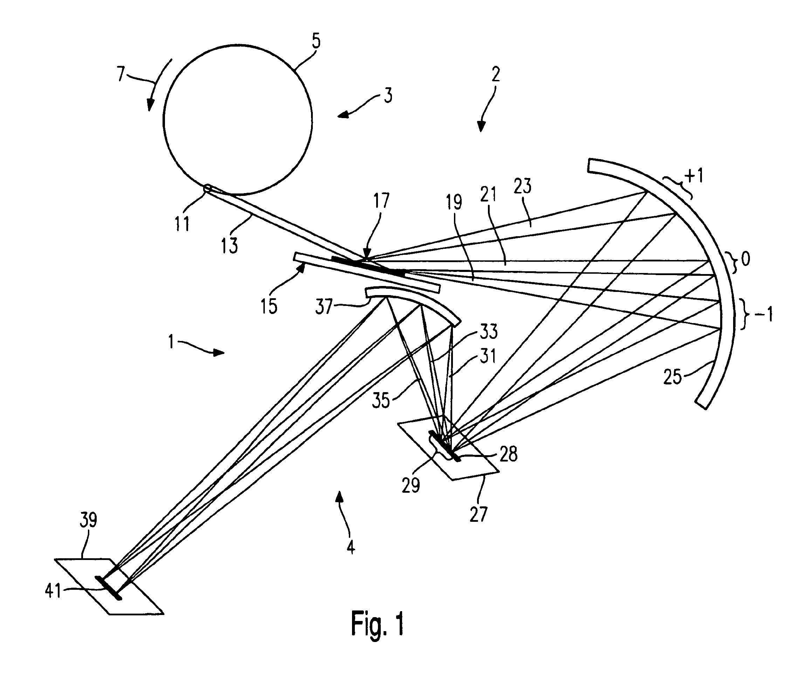

Figur 1 stellt schematisch eine Ausführungsform eines erfindungsgemäßen Belichtungssystemes 1 dar, welches ein Beleuchtungssystem 2 und ein Abbildungssystem 4 umfaßt. Das Beleuchtungssystem 1 umfaßt eine Strahlungsquelle 3 in Form eines in der Figur 1 schematisch als Ring 5 dargestellten Synchrotrons, in dem Elektronen in Richtung eines Pfeils 7 umlaufen und dabei Synchrotronstrahlung emittieren. An einer Strahlposition 11 emittierte Synchrotronstrahlung wird als Strahl 13 einer beugungsoptischen Komponente 15 zugeführt. Die Strahlzuführung kann dabei direkt oder indirekt über beispielsweise Ablenkspiegel, fokussierende Komponenten, wellenlängenselektive Komponenten usw. erfolgen. Auf der beugungsoptischen Komponente 15 ist ein Wechselwirkungsbereich 17 vorgesehen, auf den wenigstens ein Teil des Strahls 13 gerichtet ist, so daß aus Sicht des Wechselwirkungsbereichs 17 die auf diesen treffende Strahlung direkt aus einer Quelle oder einer entsprechenden virtuellen Quelle zu kommen scheint.

Sind im Strahlengang zwischen der Strahlposition 11 und dem Wechselwirkungsbereich 17 wellenlängenselektive Komponenten, wie etwa Bragg-Monochromatoren oder ähnliches angebracht, so können durch diese sämtliche möglichen Wellenlängenbereiche der Synchrotronstrahlung herausgegriffen und dem Wechselwirkungsbereich 17 zugeführt werden. Insbesondere ist dies Strahlung mit einer Strahlungswellenlänge von 0,1nm bis 100nm, bevorzugterweise 1nm bis 50nm und hierbei speziell Wellenlängen im Bereich um 13nm.

In dem Wechselwirkungsbereich 17 ist eine Gitterstruktur bereitgestellt, welche ein Reflexionsgitter für die einfallende Strahlung 13 darstellt. An dieser Gitterstruktur wird die einfallende Strahlung 13 reflektiert und dabei durch Gitterbeugung in drei Teilstrahlen 19, 21 und 23 aufgespalten, nämlich den Strahl 21 0. Ordnung, den Strahl 23 +1. Ordnung und den Strahl 19 -1. Ordnung. Hierbei ist die Divergenz der gebeugten Strahlen 19, 23 durch das Frequenzspektrum des einfallenden Strahls 13 bestimmt, da der Beugungswinkel bei gegebener Gitterperiode von der Wellenlänge des gebeugten Lichts abhängig ist.

Die Teilstrahlen 19, 21 und 23 treffen auf einen fokussierend wirkenden Kondensorspiegel 25, der die Teilstrahlen reflektiert und auf die Oberfläche einer Maske 27 richtet. Die von dem Kondensor 25 auf die Maske 27 gerichteten Teilstrahlen 19, 21, 23 beleuchten dort einen gemeinsamen flächigen Beleuchtungsfleck 29. Die Maske 27 ist eine Reflexionsmaske, die eine in Figur 1 als Gerade 28 dargestellte Struktur trägt, an der die einfallende Strahlung 19, 21, 23 reflektiert wird.

Aus Sicht der Maske 27 wird diese mit Strahlen 19, 21, 23 beleuchtet, welche aus drei verschiedenen Raumrichtungen auf die Maske 27 treffen. Entsprechend werden die Strahlen 19, 21, 23 auch durch die auf der Maske 27 vorgegebene Struktur 28 in drei verschiedene Raumrichtungen als Strahlen 31, 33, 35 reflektiert. Die reflektierten Strahlen werden von dem Abbildungssystem 4 aufgenommen und auf ein Substrat 39 abgebildet. Das Abbildungssystem 4 umfaßt einen Objektivspiegel 37, auf den die Strahlen 31, 33, 35 treffen, und der diese auf das Substrat 39 derart richtet, daß die Strukturen der Maske 27 auf das Substrat 39 abgebildet werden. In Figur 1 wird demgemäß die Linienstruktur 28 auf der Maske 27 auf das Substrat 39 abgebildet, indem dort Strahlung lediglich im Bereich eines Linienstücks 41 auf das Substrat 39 fällt.

Insgesamt ist mit dem Beleuchtungssystem 1 ein abbildendes System geschaffen, welches die Maske 27 auf das Substrat 39 abbildet, wobei die Maske 27 aus mehreren Raumrichtungen belichtet wird, obwohl der aus der Quelle 11 stammende Strahl 13 stark kollimiert ist. Es ist damit unter Zugrundelegung des einfallenden Strahls 13 mit vorgegebener Kollinearität ein Beleuchtungssystem mit vergleichsweise hoher numerischer Apertur realisiert, oder, anders ausgedrückt, die beugungsoptische Komponente 15 hat zur Erhöhung des Lichtleitwerts des Beleuchtungssystemes beigetragen.

Die durch die beugungsoptische Komponente 15 bereitgestellte Gitterstruktur ist dabei durch Ändern der Gitterperiode verstellbar, um die Beugungswinkel der Strahlen 19 und 23 der-1. bzw. +1. Ordnung zu ändern. Somit ist es möglich, die Winkel, mit denen die Strahlen 19, 23 auf die Maske 27 fallen, ebenfalls zeitlich zu variieren, so daß innerhalb einer Zeitdauer ein Raumwinkelbereich zur Beleuchtung der Maske 27 im wesentlichen vollständig ausgeleuchtet werden kann.

Neben der beschriebenen ersten (+1, -1) Beugungsordnung des einfallenden Strahles können ebenfalls höhere Beugungsordnungen (+2, -2, ...) zur Belichtung der Maske 27 eingesetzt werden.

Das Beleuchtungssystem 1 ist beispielsweise einsetzbar in einem Verfahren zur Herstellung eines miniaturisierten Bauelements und dort insbesondere in einem photolithographischen Verfahrensabschnitt. Darin wird das Substrat, in welchem das Bauelement zu fertigen ist, vorab mit einer strahlungsempfindlichen Schicht überzogen. Auf die strahlungsempfindliche Schicht wird dann mit dem Beleuchtungssystem 1 der Figur 1 das Muster der Maske 27 projeziert. Sodann wird die strahlungsempfindliche Schicht entwickelt, und nachfolgend werden ein oder mehrere Bearbeitungsschritte durchgeführt, die das Substrat bereichsweise verändern, und zwar in Abhängigkeit davon, ob der Bereich ein Bereich mit entwickelter oder nicht entwickelter photoempfindlicher Schicht ist. Als weiterer Bearbeitungsschritt kommt hier beispielsweise Ätzschritte oder Dotierungsschritte usw. in Betracht.

Das Beleuchtungssystem 1 ist in Figur 1 als vereinfachtes System in Funktionsdarstellung gezeigt. So bestehen dort der Kondensor und das Objektiv jeweils aus einem Spiegel 25 bzw. 37. Es ist jedoch möglich, die Komponenten aufwendiger zu gestalten und in dem Strahlengang noch weitere strahlformende und strahlumlenkende Komponenten einzufügen. Derartige Komponenten und deren Einsatz in einem Lithographiesystem ist beispielsweise aus US 5 973 826, US 6 033 079 und 6 142 641 bekannt.

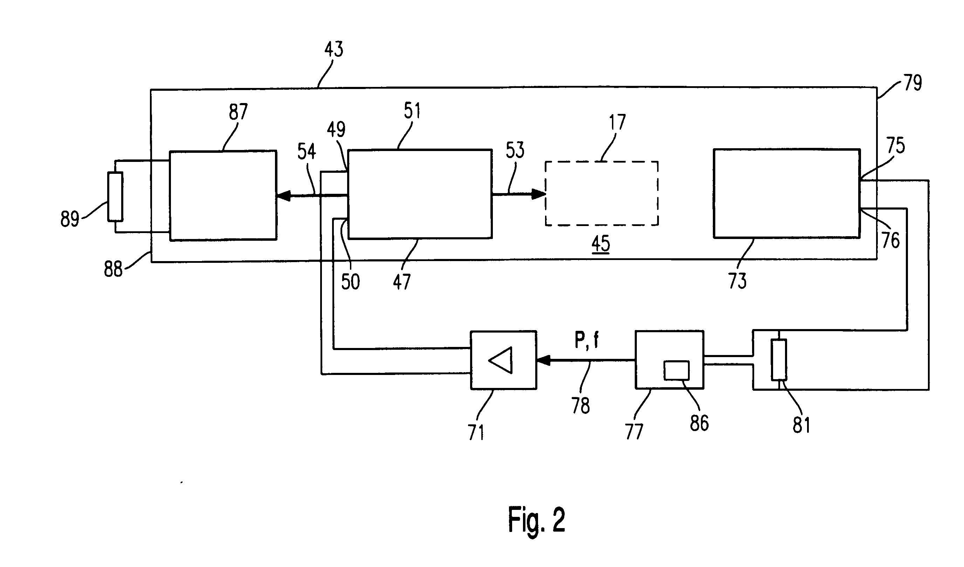

Eine wesentliche Komponente des in Figur 1 dargestellten Beleuchtungssystems 1 ist die beugungsoptische Komponente 15, auf deren Wechselwirkungsbereich 17 der einfallende und abzulenkende Strahl 13 fällt. Diese beugungsoptische Komponente ist in Figur 2 genauer dargestellt. Diese umfaßt ein Substrat 43 mit einer Substratoberfläche 45, auf welcher Oberflächenwellen mit großer Amplitude effizienz anregbar sind. Unter dem Begriff Oberflächenwellen sind hier sämtliche Wellenphänomene in der Substratmaterie zu verstehen, welche zu einer periodischen Änderung der optischen Eigenschaften der Substratoberfläche 45 führen. Es können dies akustische Oberflächenwellen (SAW, "Surface Acoustic Waves"), insbesondere Rayleigh-Wellen oder Love-Wellen oder Leck-Wellen oder Dichtewellen oder Scherwellen bzw. Transversalwellen oder Longitudinalwellen usw. sein, wobei als Transversalwellen auch senkrecht zur Oberfläche des Substrats polarisierte Oberflächenwellen sowie parallel zur Oberfläche polarisierte Oberflächenwellen, wie etwa Bleustein-Gulyaev-Wellen ausgenutzt werden können. Ferner ist es möglich, Superpositionen derartiger Wellen einzusetzen. In der nachfolgenden Beschreibung werden die akustischen Oberflächenwellen (SAWs) ausgenutzt, um die gewünschten optischen Effekte zu erzeugen, wobei es sich versteht, daß auch andere Wellenphänomene zur Erreichung der gewünschten optischen Effekte genutzt werden können.

Das Substrat 43 ist aus einem Einkristall aus Lithiumniobat (LiNbO₃) gefertigt, und zwar derart, daß die Substratoberfläche 45 eine 128°rotY-Oberfläche bildet. Das Material Lithiumniobat wurde als Substratmaterial ausgewählt, da es ein piezoelektrisches Material ist und piezoelektrische Materialien sich für die Anregung von Oberflächenwellen durch elektrische Spannungen bzw. Felder in einer Oberflächenwellenquelle 47 besonders eignen. Es gibt jedoch auch andere als Substrate 43 geeignete piezoelektrische Materialien, wie etwa Lithiumtantalat (LiTaO₃), Quarz (SiO₂), Lithium-Bor-Oxide (z.B. Li₂B₄O₇), Aluminiumphosphat (AlPO₄), Galliumarsenid (GaAs), Polybismuthite, insbesondere Bismut-Germanium-Oxide (z.B. Bi₁₂GeO₂₀ oder Bi₁₂SiO₂₀) und andere.

Die Oberflächenwellenquelle 47 umfaßt einen elektroakustischen Wandler 51, dem die zur Erzeugung der Oberflächenwellen erforderliche Energie als elektrische Energie an Anschlüssen 49 und 50 zugeführt wird.

Der elektroakustische Wandler 51 ist ein Unidirektionalwandler, was bedeutet, daß er Oberflächenwellen, die sich in eine durch einen Pfeil 53 gekennzeichnete Richtung ausbreiten, mit einer wesentlich höheren Intensität erzeugt als Oberflächenwellen, die sich in einer zu der Richtung 53 entgegengesetzte Richtung 54 ausbreiten.

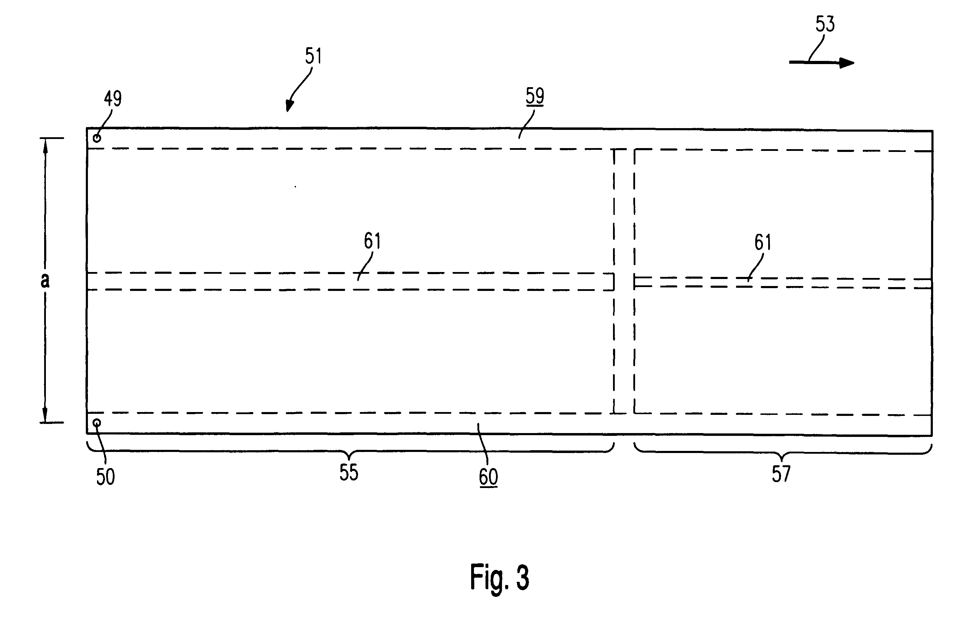

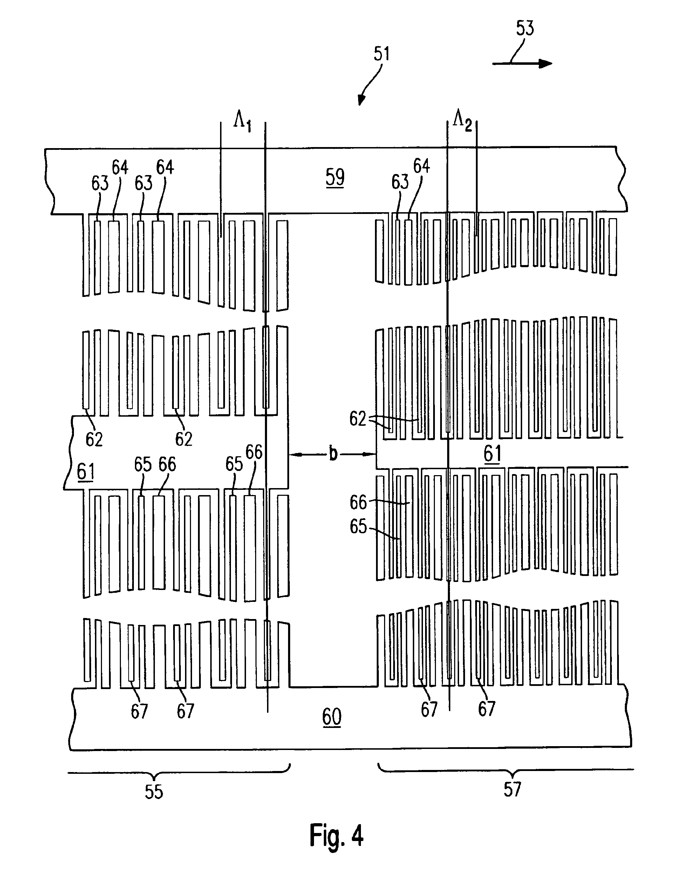

Wie aus den Detaildarstellungen der Figuren 3 und 4 ersichtlich ist, umfaßt der elektroakustische Wandler 51 einen Teilwandler 55, der im Hinblick auf die Erzeugung von Oberflächenwellen mit einer Wellenlänge Λ₁ von 30µm optimiert ist, sowie einen Teilwandler 57, der im Hinblick auf die Erzeugung von Oberflächenwellen mit einer Wellenlänge Λ₂ von 20µm optimiert ist. Es ist jedoch auch möglich, durch Ändern des Abstands zwischen den Fingerelektroden den Wandler im Hinblick auf die Emission von Oberflächenwellen anderer Wellenlängen Λ auszubilden. Insbesondere sind hier Wellenlängen Λ in Bereichen von etwa 2µm bis 100µm, insbesondere 4µm bis 50µm bei Anregungsfrequenzen von 50MHz bis 2GHz, vorgesehen.

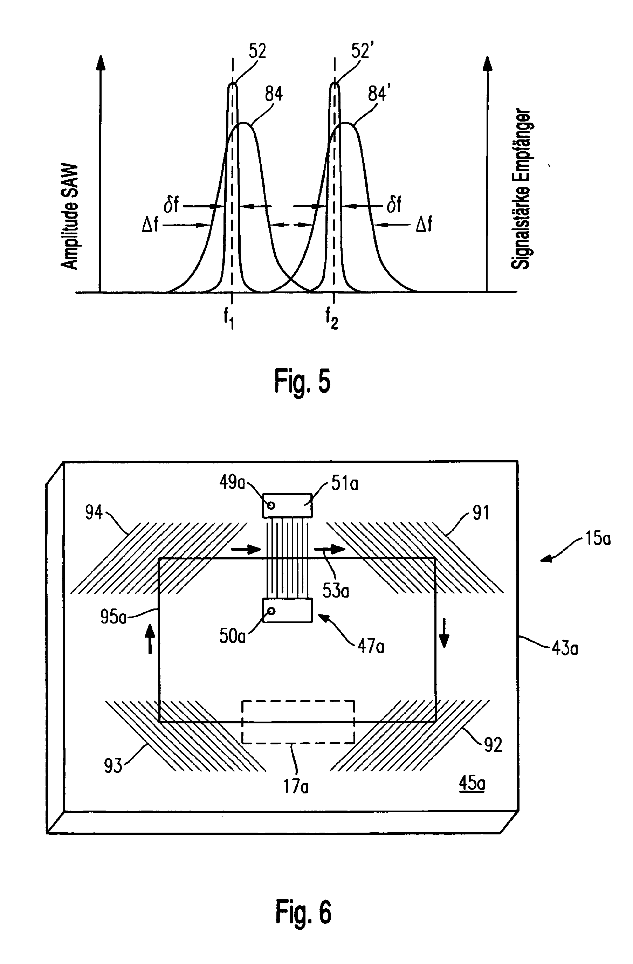

Figur 5 zeigt mit den Kurven 52 und 52' eine Frequenzcharakteristik des elektroakustischen Wandlers 51. Hierbei stellt die Kurve 52 die von dem Teilwandler 55 abgestrahlte Oberflächenwellenintensität in Abhängigkeit von der elektrischen Anregungsfrequenz des Wandlers dar, während die Kurve 52' dies entsprechend für den Teilwandler 57 darstellt. Die beiden Teilwandler 55, 57 erzeugen Oberflächenwellen bei jeweils verschiedenen Frequenzen f₁ bzw. f₂ mit maximaler Intensität. Die hohe Frequenz f₂ ist so eingestellt, daß der Teilwandler 57 die Oberflächenwellen mit Λ₂ = 20µm mit maximaler Amplitude erzeugt und diese in die Richtung 53 abstrahlt, während bei Anregung mit der niedrigen Frequenz f₁ der Teilwandler 55 zur Erzeugung der Oberflächenwellen mit Λ₁ = 30µm mit maximaler Amplitude beiträgt und diese ebenfalls in Richtung 53 abstrahlt, wobei die abgestrahlten Oberflächenwellen den Teilwandler 57 durchlaufen.

Der Wandler 51 umfaßt eine Mehrzahl von Fingerelektrodensätzen, sogenannten Interdigitalelektroden, wie dies aus Figur 4 deutlich wird, die einen Bereich vergrößert darstellt, in dem die Teilwandler 55 und 57 der Figur 3 aneinandergrenzen.

Der Wandler 51 umfaßt eine Sammelelektrode 59, an der der elektrische Anschluß 49 vorgesehen ist und die sich in Emissionsrichtung 53 erstreckt. Eine weitere Sammelelektrode 60 erstreckt sich parallel zu der Sammelelektrode 59 mit einem Abstand a von etwa 1 mm, und diese zweite Sammelelektrode 60 wird von dem Anschluß 50 gespeist.

Ein jeder Teilwandler 55, 57 weist eine Zwischenelektrode 61 auf, die sich mittig zwischen den Sammelelektroden 59 und 60 erstreckt, wobei die Zwischenelektrode 61 des Teilwandlers 55 eine Breite von 50µm aufweist und die Sammelelektrode 61 des Teilwandlers 57 eine Breite von 20µm aufweist.

In einem jeden der Teilwandler 55, 57 erstrecken sich Fingerelektroden 62, 63, 64, 65, 66 und 67 senkrecht zur Emissionsrichtung 53 zwischen der Sammelelektrode 59 und der Zwischenelektrode 61 bzw. der Zwischenelektrode 61 und der Sammelelektrode 60. Hierbei gehen von der Sammelelektrode Fingerelektroden 62 aus, die voneinander den Mittenabstand Lambda aufweisen, jeweils eine Breite von Λ₁/8 bzw. Λ₂/8 aufweisen und mit einem Abstand von 5µm von der Zwischenelektrode 61 enden. Zwischen einem jeden Paar von Fingerelektroden 62 sind zwei Fingerelektroden 63 und 64 angeordnet, die jeweils von der Zwischenelektrode 61 ausgehen und mit einem Abstand von ebenfalls 5 µm vor der Sammelelektrode 59 enden. Die Fingerelektrode 64 weist hierbei eine Breite von Λ₁/4 bzw. Λ₂/4 auf und ist bezüglich der Fingerelektrode 63 in Emissionsrichtung 53 versetzt und unmittelbar benachbart zu der Fingerelektrode 63 angeordnet. Die Fingerelektrode 63 weist eine Breite von Λ₁/8 bzw. Λ₂/8 auf.

Die Struktur der sich zwischen der Zwischenelektrode 61 und der Sammelelektrode 60 erstreckenden Fingerelektroden 65, 66 und 67 entspricht der Struktur der sich zwischen der Sammelelektrode 59 und der Zwischenelektrode 61 erstreckenden Fingerelektroden 62, 63 und 64, indem sich die Fingerelektroden 67 jeweils fluchtend mit den Fingerelektroden 62 erstrecken, eine Breite von Λ₁/8 bzw. Λ₂/8 aufweisen und von der Zwischenelektrode 61 ausgehen. Die Fingerelektroden 65 weisen eine Breite von ebenfalls Λ₁/8 bzw. Λ₂/8 auf, gehen von der Sammelelektrode 60 aus und fluchten jeweils mit den Fingerelektroden 63. Die Fingerelektroden 66 weisen eine Breite von Λ₁/4 bzw. Λ₂/4 auf, gehen von der Sammelelektrode 60 aus und fluchten jeweils mit den Fingerelektroden 64.

Somit fluchtet eine jede von der Sammelelektrode 59 ausgehende Fingerelektrode 62 mit einer von der Zwischenelektrode 61 ausgehenden Fingerelektrode 67, und eine jede von der Sammelelektrode 60 ausgehende Fingerelektrode 65, 66 fluchtet mit einer entsprechenden von der Zwischenelektrode 61 ausgehenden Fingerelektrode 63 bzw. 64. Allerdings sind die von der Sammelektrode 59 ausgehenden Fingerelektroden 62 jeweils versetzt zu Fingerelektroden 65, 66 angeordnet, die von der Sammelelektrode 60 ausgehen.

Durch diese Anordnung der Fingerelektroden entsteht eine Reihenschaltung, bei der die zwischen der Sammelelektrode 59 und der Zwischenelektrode 61 angeordneten Wandlerbereiche elektrisch in Reihe zu den zwischen der Zwischenelektrode 61 und der Sammelelektrode 60 angeordneten Wandlerbereichen geschaltet sind. Dies führt zu einer Spannungsteilung, so daß zwischen benachbarten Paaren von Teilelektroden (62-63, 64-62, 67-65, 66-67) nur die Hälfte der Spannung anliegt, die im Betrieb zwischen den Anschlüssen 49 und 50 anliegt.

Die Teilwandler 55 und 57 weisen voneinander einen Abstand b von 53,7µm auf, d.h. daß der nicht mit Elektroden versehene Bereich zwischen den Teilwandlern 55, 57 diese Breite b aufweist.

In Emissionsrichtung 53 weist der Teilwandler 55 eine Länge von 60 Λ₁ (Λ₁=30µm) und der Teilwandler 57 eine Länge von 50 Λ₂ (Λ₂=20µm) auf.

Die beschriebene Elektrodenstruktur wird auf der Substratoberfläche durch Abscheiden eines Aluminiumfilms gebildet, aus dem dann mittels mikrolithographischer Verfahren die Lücken zwischen den einzelnen Elektroden herausgeätzt werden. Alternativ zur Ausbildung der Elektrodenstruktur aus Aluminium ist es auch möglich, hierzu andere Elemente, insbesondere Metalle, wie etwa Kupfer, einzusetzen.

Die Oberflächenwellenquelle 47 wird durch einen Verstärker 71 gespeist, der an die Anschlüsse 49 und 50 angeschlossen ist. Die von der Oberflächenwellenquelle 47 in Richtung 53 emittierten Oberflächenwellen durchlaufen den Wechselwirkungsbereich 17 und bilden dort die zur Ablenkung des einfallenden Strahls 13 erforderliche strahlungsbeugende Gitterstruktur. Im Hinblick auf eine möglichst hohe Beugungseffizienz soll dabei, bei gegebener Wellenlänge Λ der Oberflächenwellen, die der Quelle 47 durch den Verstärker 71 zugeführte elektrische Energie und die hierzu verwendete Frequenz f so eingestellt werden, daß die Gitteramplitude, d.h. die Amplitude der Oberflächenwellen in dem Wechselwirkungsbereich 17, möglichst maximal ist.

Hierzu umfaßt die beugungsoptische Komponente 15 weiterhin einen Oberflächenwellenempfänger 73, der ebenfalls im Ausbreitungsweg der von der Quelle 47 emittierten Oberflächenwellen liegt und auf den die Oberflächenwellen nach Durchlaufen des Wechselwirkungsbereichs 17 treffen. Der Oberflächenwellenempfänger 73 umfaßt einen akustoelektrischen Wandler, der mechanische Energie der Oberflächenwellen in elektrische Energie umwandelt und diese elektrische Energie an Anschlüssen 75 und 76 bereitstellt.

Die Spannung zwischen den Anschlüssen 75 und 76 ist damit ein Signal, welches die Intensität der Oberflächenwellen am Ort des Empfängers 73 repräsentiert, und wird von einer Steuerung 77 erfaßt. Die Steuerung 77 wiederum wirkt, wie in Figur 2 durch einen Pfeil 78 dargestellt ist, auf den Verstärker 71 und gibt diesem die Leistung und Frequenz vor, welche der Quelle 47 zuzuführen ist. Die Steuerung 77 ändert die Größen Leistung P und Frequenz f dabei derart, daß das an den Anschlüssen 75 und 76 abgegriffene Signal maximal wird. Da davon ausgegangen werden kann, daß die Amplitude der Oberflächenwellen im Wechselwirkungsbereich 17 dann maximal ist, wenn ebenfalls der Empfänger 73 maximale Oberflächenwellenamplitude erfaßt, führt diese Schaltung dazu, daß die Quelle 47 so angesteuert werden kann, daß die Oberflächenwellenamplitude im Wechselwirkungsbereich 17 maximal ist.

Der akustoelektrische Wandler des Empfängers 73 ist ähnlich aufgebaut wie der elektroakustische Wandler 51 der Quelle 47, d.h. der akustoelektrische Wandler umfaßt ebenfalls eine Vielzahl von Fingerelektroden bzw. Interdigitalelektroden, welche an die Anschlüsse 75 und 76 angeschlossen sind. In dem Ausführungsbeispiel der Figur 2 weist der akustoelektrische Wandler des Empfängers 73 eine Elektrodenstruktur auf, die der Elektrodenstruktur des elektroakustischen Wandlers 51 im wesentlichen entspricht. Im Unterschied hierzu ist die Struktur jedoch bezüglich einer Mittelebene zwischen der Quelle 47 und dem Empfänger 73 symmetrisch aufgebaut, so daß den breiten Fingerelektroden 64, 66 der Quelle 47 entsprechende Elektroden des Empfängers 73 in Emissionsrichtung 53 neben den jeweils benachbarten schmalen Elektroden angeordnet sind, die den Elektroden 63, 65 entsprechen. Hierdurch erhält auch der Empfänger 73 eine Unidirektionalcharakteristik, d.h. er empfängt in Richtung 53 sich ausbreitende Oberflächenwellen mit höherer Effizienz als sich entgegengesetzt hierzu ausbreitende Oberflächenwellen.

Der Oberflächenwellenempfänger 73 erfüllt neben der Funktion zur Steuerung der Quelle 47 zuzuführenden Leistung P und Frequenz f auch noch eine Funktion als Oberflächenwellendämpfer. Oberflächenwellen, die sich nach Durchlaufen des Wechselwirkungsbereichs 17 weiter auf dem Substrat ausbreiten, werden nämlich wenigstens teilweise an einem Rand 79 des Substrats 43 reflektiert und können dadurch wieder zurück in den Wechselwirkungsbereich 17 gelenkt werden und würden dort die durch die Oberflächenwellen beabsichtigte Gitterstruktur stören und zu einer Verminderung der Qualität der erzielten Strahlablenkung führen. Deshalb ist es ein Ziel, die Oberflächenwellen in dem Empfänger 73 möglichst vollkommen zu absorbieren, so daß im wesentlichen keine Oberflächenwellenintensität an den Rand 79 des Substrats 43 gelangt und dort reflektiert wird.

Hierzu ist der Empfänger 73 dahingehend optimiert, daß er möglichst viel der mechanischen Energie der Oberflächenwellen in elektrische Energie umwandelt, wobei diese elektrische Energie über an die Anschlüsse 75 und 76 angeschlossene Leitungen abgeführt und in einem Widerstand 81 dissipiert wird. Der Widerstand 81 ist dabei entfernt von dem Substrat angeordnet, so daß die in dem Widerstand 81 entstrehende Wärme das Substrat 43 und insbesondere den Wechselwirkungsbereich 17 nicht erwärmt und die optische Wirkung der Oberflächenwellen nicht durch Temperatureinflüsse beeinträchtigt wird. Um die an den Anschlüssen 75 und 76 des Empfängers 73 bereitgestellte elektrische Energie möglichst effizient in den Widerstand 81 zu dissipieren, ist dieser nicht als rein ohmscher Widerstand, sondern als komplexwertige Impedanz ausgebildet, deren Impedanzwert an die Impedanz des Empfängers 73 angepaßt ist, indem die Impedanzwerte des Widerstands 81 und des Empfängers 73 im wesentlichen zueinander konjugiert komplexe Werte aufweisen.

In dem in Figur 2 gezeigten Ausführungsbeispiel sind die Funktionen des Empfängers 73, nämlich zum einen die Bereitstellung eines Meßsignals für die Steuerung der Quelle 47 und zum anderen die Dämpfung der Oberflächenwellen, die den Wechselwirkungsbereich 17 durchlaufen haben, in einem Bauelement vereinigt. Es ist jedoch ebenfalls möglich, diese Funktionen in getrennte Bauelemente zu separieren und den Empfänger zur Bereitstellung des Meßsignals für die Steuerung der Quelle 47 in Ausbreitungsrichtung 53 vor einer weiteren Komponente anzuordnen, die lediglich die Funktion des Oberflächenwellendämpfers aufweist.

Wie aus Figur 5 ersichtlich ist, weist die Quelle 47 eine schmalbandige Frequenzcharakteristik 52, 52' auf, d.h. eine Intensität der emittierten Oberflächenwellen fällt in Abhängigkeit von der Anregungsfrequenz beidseits eines Maximums bei der Frequenz f mit einer charakteristischen Breite δf ab.

In Figur 5 ist ebenfalls die Frequenzcharakteristik des Oberflächenwellenempfängers 73 als Linien 84 und 84' eingetragen, welche die Größe des an den Anschlüssen 75 und 76 bereitgestellten Meßsignals in Abhängigkeit von der Frequenz der eintreffenden Oberflächenwellen darstellt. Auch die Linien 84 und 84' weisen beidseits einer Mittenfrequenz mit einer Breite Δf abfallende Charakteristiken auf. Wie aus Figur 5 hervorgeht, sind die charakteristischen Frequenzbreiten Δf des Empfängers 73 größer als die Frequenzbreiten δf der Quelle 47. Hierdurch ist der Empfänger 73 unempfindlich gegenüber geringfügigen Frequenzänderungen der Quelle 47, so daß die Steuerung 77 innerhalb eines gewissen Frequenzbereichs die Quelle 47 alleine aufgrund des Meßsignals an den Anschlüssen 75, 76 im Hinblick auf eine maximale Amplitude der Oberflächenwellen im Wechselwirkungsbereich 17 steuern kann.

Im vorliegenden Ausführungsbeispiel weist die Steuerung 77 allerdings zudem einen Speicher 86 auf, in dem die frequenzabhängige Empfindlichkeit des Empfängers 73, d.h. der Verlauf der Kurve 84 der Figur 5, abgespeichert ist. Hierdurch ist es möglich, auch bei Frequenzen, die weiter von der Zentralfrequenz der Linie 84 entfernt sind, wie dies in Figur 5 für die Anregungsfrequenz f3 der Fall ist, die Quelle 47 zuverlässig anzusteuern.

Die im Vergleich zu der Oberflächenwellenquelle 47 vergrößerten Frequenzbreiten Δf des Oberflächenwellenempfängers 73 werden dadurch erreicht, daß für den akustoelektrischen Wandler des Empfängers 73 prinzipiell die gleiche Elektrodenstruktur gewählt wird wie für den elektroakustischen Wandler der Quelle 47. Insofern weist der akustoelektrische Wandler des Empfängers 73 die gleiche Elektrodenstruktur auf, wie dies in der Figur 4 für den akustoelektrischen Wandler 51 der Quelle gezeigt ist. Allerdings ist der Wandler der Quelle 73 in der Richtung 53 kürzer ausgebildet als der Wandler der Quelle 47, das heißt, der Wandler des Empfängers 73 weist weniger Fingerelektroden auf als der Wandler der Quelle 47. In der vorliegenden Ausführungsform weist in dem akustoelektrischen Wandler des Empfängers 73 der eine Teilwandler eine Länge von 40 Λ₁ und der andere Teilwandler eine Länge von 35 Λ₂ auf.

Ein weiterer Unterschied zwischen den Elektrodenstrukturen des Wandlers der Quelle 47 und des Wandlers des Empfängers 73 liegt in dem Abstand der Elektrodenfinger voneinander. Während des Betriebes weist das Substrat in der Umgebung der Quelle 47 nämlich eine höhere Temperatur auf als das Substrat in der Umgebung des Empfängers 73, wodurch sich ein Unterschied in den Wellenlängen der Oberflächen am Ort der Quelle 47 und am Ort des Empfängers 73 ergibt. Am Ort des Empfängers 73 ist dann nämlich die Wellenlänge um etwa 0.5% geringer als am Ort der Quelle 47. Deshalb ist die Struktur des Wandlers in dem Empfänger 73 gegenüber dem Wandler in der Quelle 47 geometrisch um 0,5% nach unten skaliert, so daß für die Bemessung des Wandlers in dem Empfänger 73 als Parameter Λ₁ 29,85µm und als Parameter Λ₂ 19,9µm eingesetzt sind. Deshalb sind die Mittelfrequenzen der Frequenzcharakteristiken 84 und 84' gegenüber den Frequenzen f₁ bzw. f₂ jeweils geringfügig hin zu höheren Frequenzen versetzt. Hierbei zeigt die Figur 5 die Frequenzcharakteristiken 52, 52', 84, 84' bei einer Messung, bei der Quelle 47 und Empfänger 73 gleiche Temperaturen aufweisen, so daß der Unterschied zwischen den Mittenfrequenzen der Frequenzcharakteristiken deutlich wird. Während eines Dauerbetriebs stellt sich zwischen Quelle 47 und Empfänger 73 ein Temperaturunterschied von etwa 70K ein, so daß dann die Mittenfrequenzen der Charakteristiken 52 und 84 bzw. 52' und 84' in etwa zusammenfallen.

Da die Oberflächenwellenquelle 47 nicht eine perfekte Unidirektionalcharakteristik aufweist und deshalb mit einer gewissen Intensität auch Oberflächenwellen in die Richtung 54 emittiert, ist in Richtung 54 neben der Quelle 47 ein weiterer Oberflächenwellendämpfer 87 vorgesehen, um diese in Richtung 54 emittierten Oberflächenwellen zu absorbieren und deren Reflexion an einem Rand 88 des Substrats 43 zurück zu dem Wechselwirkungsbereich 17 zu verhindern. Auch der Oberflächenwellendämpfer 87 ist als akustoelektrischer Wandler ausgebildet, der die mechanische Energie der Oberflächenwellen in elektrische Energie umwandelt, welche in einem entsprechend angepaßten Widerstand 89 dissipiert wird.

Neben dem im Zusammenhang mit den Figuren 3 und 4 erläuterten elektroakustischen Wandler ist es auch möglich, andere Wandlertypen mit Unidirektionalcharakteristik einzusetzen. Es kommen dabei sowohl sogenannte einphasige als auch mehrphasige Oberflächenwellenerzeuger in Frage. Beispiele hierzu sind beispielsweise den Schriften 4 521 711, US 4 736 172, US 4 910 839, US 5 073 763, US 5 162 689, US 5 264 751, US 5 365 206 und US 6 147 574 zu entnehmen, deren Offenbarung in die vorliegende Anmeldung voll umfänglich aufgenommen wird.

Im folgenden werden Varianten der im Zusammenhang mit den Figuren 1 bis 5 erläuterten Ausführungsformen dargestellt. Hinsichtlich ihres Aufbaus und ihrer Funktion einander entsprechende Komponenten sind nachfolgend mit den Bezugsziffern aus den Figuren 1 bis 5 versehen, zur Unterscheidung jedoch durch einen zusätzlichen Buchstaben ergänzt. Zur Erläuterung wird auf die gesamte vorangehende Beschreibung Bezug genommen.

Figur 6 zeigt eine weitere Ausführungsform einer beugungsoptischen Komponente 15a, welche ein Substrat 43a aus piezoelektrischem Material mit einer Substratoberfläche 45a umfaßt. Auf der Substratoberfläche 45a ist eine Oberflächenwellenquelle 47a angeordnet, welche als elektroakustischer Wandler mit Anschlüssen 49a und 50a ausgebildet ist. Die Interdigitalelektroden des elektroakustischen Wandlers sind in Figur 6 lediglich schematisch dargestellt.

Auch der elektroakustische Wandler 51a weist eine Unidirektionalcharakteristik auf, so daß er bevorzugt Oberflächenwellen in eine durch einen Pfeil 53a bezeichnete Richtung emittiert.

Die von der Quelle 47a emittierten Oberflächenwellen treffen zunächst auf einen in Figur 6 durch ein Strichgitter symbolisierten Oberflächenwellenspiegel 91, werden von diesem bezüglich ihrer ursprünglichen Ausbreitungsrichtung 53a um 90° abgelenkt, treffen sodann nacheinander auf weitere Oberflächenwellenspiegel 92, 93 und 94, welche sie jeweils um 90° reflektieren und welche derart auf dem Substrat 45a positioniert sind, daß die Oberflächenwellen nach ihrer Reflexion an dem letzten Spiegel 94 wieder in ihrer ursprünglichen Ausbreitungsrichtung 53a verlaufen und sich auf die Quelle 47a zubewegen. Die Spiegel 91 bis 94 bilden somit einen kreisförmig geschlossenen Ausbreitungsweg 95a für die Oberflächenwellen, wobei die Quelle 47a in diesem geschlossenen Ausbreitungsweg 95a liegt und Oberflächenwellen in diesen Ausbreitungsweg einspeist.

Im Ausbreitungsweg zwischen den Spiegeln 92 und 93 ist ein Wechselwirkungsbereich 17a angeordnet, welcher für die Wechselwirkung der durch die Oberflächenwellen in diesem Bereich gebildete Struktur mit einfallender abzulenkender bzw. zu beugender Strahlung vorgesehen ist.

Gegenüber der in Figur 2 gezeigten Ausführungsform der beugungsoptischen Komponente weist die in Figur 6 gezeigte Ausführungsform den Vorteil auf, daß die Oberflächenwellen, die den Wechselwirkungsbereich 17a durchlaufen haben, nicht absorbiert werden und damit deren Energie vernichtet wird. Vielmehr bleiben diese Oberflächenwellen in dem kreisförmig geschlossenen Ausbreitungsweg 95a auf dem Substrat 45a gespeichert und können nochmals zur Ausbildung der Gitterstruktur im Wechselwirkungsbereich 17a beitragen. Hierbei wird die Quelle 47a durch eine in Figur 6 nicht gezeigte Steuerung vorteilhafterweise so angesteuert, daß sich die von dem Spiegel 94 der Quelle 47a zugeleiteten Oberflächenwellen und die durch die Quelle 47a selbst erzeugten Oberflächenwellen konstruktiv überlagern.

Ähnlich wie bei der in Figur 2 gezeigten Ausführungsform ist auch in dem geschlossenen Ausbreitungsweg 95a der Oberflächenwellen ein Oberflächenwellenempfänger angeordnet, um die Oberflächenwellenquelle 47a optimiert anzusteuern.

Die Spiegel 91, 92, 93, 94 sind als Bragg-Spiegel mit einem Strichgitter ausgebildet, wobei die Striche durch in die Substratoberfläche 45a eingeätzte Gruben gebildet sind. Es ist allerdings auch möglich, die Gitterstriche durch Metallisierungsfilme zu bilden, welche auf die Substratoberfläche aufgebracht sind.

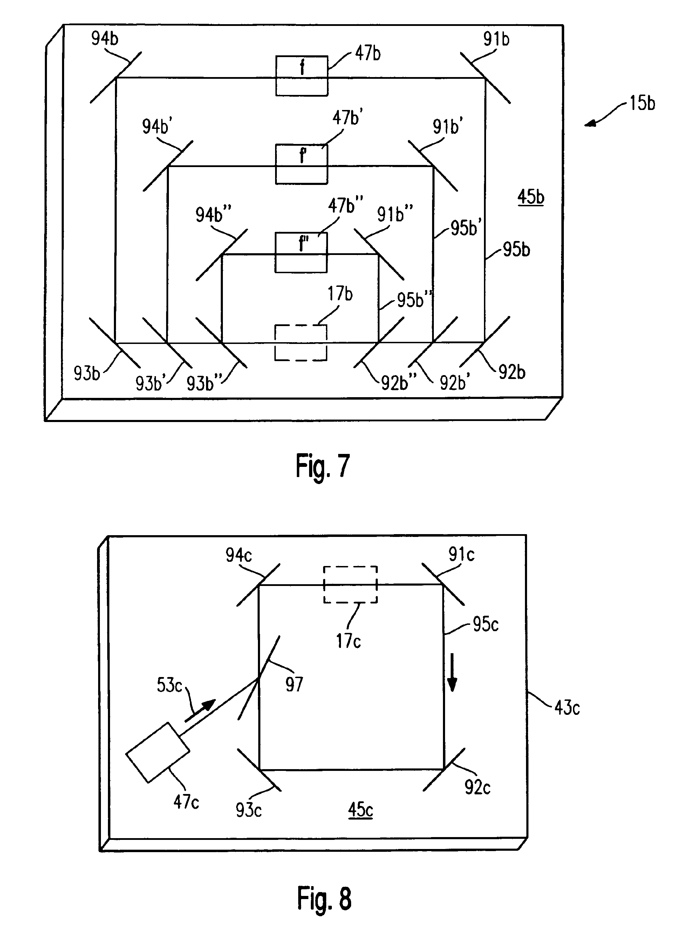

Figur 7 zeigt eine Substratoberfläche 45b einer beugungsoptischen Komponente 15b, bei der eine Oberflächenwellenquelle 47b Oberflächenwellen einer Frequenz f₁ in eine Vorzugsrichtung 53b emittiert. Über Spiegel 91b, 92b, 93b und 94b wird für die Oberflächenwellen der Frequenz f₀ ein geschlossener Ausbreitungsweg 95b bereitgestellt, so daß die Oberflächenwellen nach Durchlaufen des abgeschlossenen Ausbreitungswegs 95b schließlich die Oberflächenquelle 47b wieder durchlaufen und dort verstärkt werden, ähnlich wie dies im Zusammenhang mit der Ausführungsform der Figur 6 bereits beschrieben wurde. Ein Wechselwirkungsbereich für abzulenkende bzw. zu beugende Strahlung ist zwischen den Spiegeln 92b und 93b angeordnet.

Neben der Oberflächenwellenquelle 47 sind auf dem Substrat zwei weitere Oberflächenwellenquellen 47b' und 47b" angeordnet, welche Oberflächenwellen mit Frequenzen f' und f" emittieren, wobei die Frequenzen f' und f" voneinander und von der Frequenz f der Quelle 47b verschieden sind. Für jede der Quellen 47b' und 47b" ist ebenfalls ein geschlossener Ausbreitungsweg 95b' bzw. 95b" für Oberflächenwellen auf dem Substrat vorgesehen, und zwar durch Spiegel 91b', 92b', 93b' und 94b' bzw. 91b", 92b", 93b" und 94b".

Die geschlossenen Ausbreitungswege 95b, 95b', 95b" für Oberflächenwellen der Frequenzen f, f', f" verlaufen dabei gemeinsam durch den Wechselwirkungsbereich 17b und werden nachfolgend durch die Spiegel 93b", 93b' und 93b aufgeteilt, um wieder den Oberflächenwellenquellen 47b, 47b', 47b" für die Frequenzen f, f' bzw. f" zugeführt zu werden. Hierbei reflektiert der Spiegel 93b" Oberflächenwellen der Frequenz f", während er für Oberflächenwellen der Frequenzen f' und f transparent ist. Entsprechend reflektiert der Spiegel 93b' Oberflächenwellen der Frequenz f', während er für Oberflächenwellen der Frequenz f ebenfalls transparent ist. Die Zusammenführung der nach Durchlaufen der jeweiligen Quellen 47b, 47b' und 47b" getrennten Ausbreitungswege erfolgt durch die Spiegel 92b, 92b' und 92b", wobei die Spiegel 92b' und 92b" für die Oberflächenwellen der Frequenz f transparent sind und der Spiegel 92b" für Oberflächenwellen der Frequenzen f und f' ebenfalls transparent ist.

Eine jede der Quellen 47b, 47b' und 47b" emittiert Oberflächenwellen in einem Frequenzspektrum, welches je nach Ansteuerfrequenz für die Quelle in einem gewissen Bereich änderbar ist. Allerdings sind die Frequenzen f, f' und f", bei denen die Quellen mit höchster Effizienz emittieren, voneinander verschieden (f"<f'<f), so daß durch wahlweises Ansteuern der drei verschiedenen Quellen in dem Wechselwirkungsbereich 17b ein vergleichsweise breites Frequenzspektrum an Oberflächenwellen bereitgestellt werden kann. Entsprechend sind die Ablenkwinkel, die durch die durch die Oberflächenwellen gebildete Gitterstruktur für die auftreffende Strahlung erzeugt werden können, in einem besonders breiten Bereich variierbar.

Die Quellen 47b, 47b' und 47" können zeitlich sequentiell angesteuert werden, so daß die verschiedenen Ablenkwinkel auch zeitlich nacheinander bereitgestellt werden. Ebenso ist es möglich, die Quellen 47b, 47b' und 47" gleichzeitig anzusteuern, so daß die Überlagerung der entsprechenden Oberflächenwellen mit verschiedenen Wellenlängen zu einem Mehrfachgitter führt, welches die verschiedenen Ablenkwinkel gleichzeitig bereitstellt. Durch phasenrichtige Überlagerung der Oberflächenwellen mit den Frequenzen f, f' und f" und geeignete Auswahl dieser Frequenzen ist es möglich, diese derart zu überlagern (zu superponieren), daß eine periodische Gitterform entsteht, die von der sinusähnlichen Gittergestalt abweicht. Es kann hierdurch insbesondere ein sog. "blazed" Gitter bereitgestellt werden, bei dem bestimmte Beugungsordnungen gezielt mit höherer Beugungsintensität entstehen als andere Beugungsordnungen.

Alternativ zu den in Figur 7 gezeigten drei Oberflächenwellenquellen 47b, 47b' und 47b" ist es ebenfalls möglich, ebenfalls zwei oder vier oder mehr Oberflächenwellenquellen mit jeweils geschlossenen Ausbreitungswegen vorzusehen, wobei die getrennten Ausbreitungswege allerdings so angeordnet sind, daß sie zusammen durch den Wechselwirkungsbereich verlaufen.

Alternativ ist es ebenfalls möglich, mehrere nebeneinander angeordnete Oberflächenwellenquellen vorzusehen, deren Ausbreitungswege, ähnlich wie dies in Figur 7 durch die Spiegel 92b, 92b' und 92b" dargestellt ist, im Wechselwirkungsbereich zu vereinigen und dann allerdings nach Durchlaufen des Wechselwirkungsbereichs die Oberflächenwellen nicht mehr zu den Quellen zurückzuführen.

Bei den Ausführungsformen der Figuren 6 und 7 sind geschlossene Ausbreitungswege für die Oberflächenwellen vorgesehen, wobei die Oberflächenwellenquellen innerhalb der geschlossenenen Ausbreitungswege liegen. Im Unterschied hierzu zeigt Figur 8 eine Ausführungsform, bei der auf einer Oberfläche 45c eines Substrats 43c durch Spiegel 91c, 92c, 93c, 94c ein geschlossener Ausbreitungsweg 95c bereitgestellt ist, wobei zwischen den Spiegeln 94c und 91c ein Wechselwirkungsbereich 17c für auftreffende Strahlung angeordnet ist, der von dem Ausbreitungsweg 95c durchlaufen wird.

Eine Oberflächenwellenquelle 47c ist außerhalb des geschlossenen Ausbreitungswegs 95c angeordnet und emittiert Oberflächenwellen in eine Vorzugsrichtung 53c. Dabei ist die Oberflächenwellenquelle 47c auf der Substratoberfläche 45c derart angeordnet, daß die von ihr emittierten Oberflächenwellen auf einen Spiegel 97 treffen, der zwischen den Spiegeln 93c und 94c in dem Ausbreitungsweg 95c angeordnet ist. Dabei ist der Spiegel 97 derart orientiert, daß er die von der Quelle 47c in die Richtung 53c emittierten Oberflächenwellen auf den Spiegel 94c lenkt und somit den bereits auf dem geschlossenen Ausbreitungsweg 95c umlaufenden Oberflächenwellen überlagert. Für die von dem Spiegel 93c kommenden Oberflächenwellen ist der Spiegel 97 im wesentlichen transparent.

Durch die Spiegel 91c bis 94c ist somit ein Ringresonator für Oberflächenwellen gebildet, welcher durch die Quelle 47c mit Oberflächenwellen gespeist wird, die über den Spiegel 97c in dem Ringresonator eingekoppelt werden.

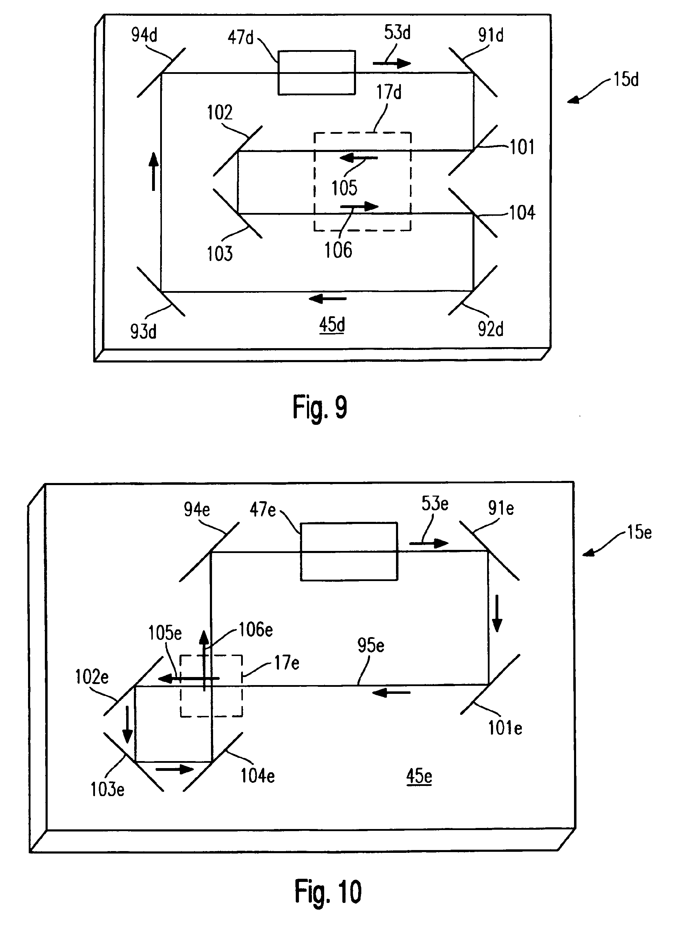

Figur 9 zeigt eine beugungsoptische Komponente 15d mit einer Substratoberfläche 45d, auf der ein Wechselwirkungsbereich 17d zur Ablenkung von Strahlung mittels Oberflächenwellen vorgesehen ist. Die Oberflächenwellen werden von einer Quelle 47d in einer Vorzugsrichtung 53d emittiert. Die von der Quelle 47d emittierten Oberflächenwellen treffen der Reihe nach auf Spiegel 91d, 101, 102, 103, 104, 92d, 93d und 94d. Der Wechselwirkungsbereich ist zwischen den Spiegeln 102 und 103 einerseits und den Spiegeln 101 und 104 andererseits angeordnet und wird damit von den Oberflächenwellen zweimal durchlaufen, nämlich einmal in eine Richtung 105 von Oberflächenwellen, die von dem Spiegel 101 zu dem Spiegel 102 verlaufen, und zum anderen in eine zur Richtung 105 entgegengesetzte Richtung 106 von Oberflächenwellen, die von dem Spiegel 103 zu dem Spiegel 104 verlaufen.

Figur 10 zeigt eine weitere beugungsoptische Komponente 15e, bei der von einer Oberflächenwellenquelle 47e in eine Richtung 53e emittierte Oberflächenwellen auf einer Substratoberfläche 50e ebenfalls in einem geschlossenen Ausbreitungsweg 95e umlaufen. Ähnlich wie bei der Ausführungsform der Figur 9 wird auch hier ein Wechselwirkungsbereich 17e von den Oberflächenwellen in zwei verschiedene Richtungen 105e und 106e durchlaufen, welche allerdings im Unterschied zu der Ausführungsform der Figur 9 nicht entgegengesetzt sondern orthogonal zueinander orientiert sind. Hierzu werden die von der Quelle 47e emittierten Oberflächenwellen der Reihe nach an Spiegeln 91e, 101e, 102e, 103e, 104e und 94e reflektiert, bevor sie wieder der Quelle 47e zugeführt werden, wie dies aus Figur 10 ersichtlich ist.

Indem der Wechselwirkungsbereich 17e in zwei zueinander orthogonalen Richtungen 105e und 106e von Oberflächenwellen durchlaufen wird, wird dort durch die Oberflächenwellen eine zweidimensionale Gitterstruktur gebildet, was ebenfalls zu einer Ablenkung der auf den Wechselwirkungsbereich 17e fallenden Strahlung in zwei Raumrichtungen führt.

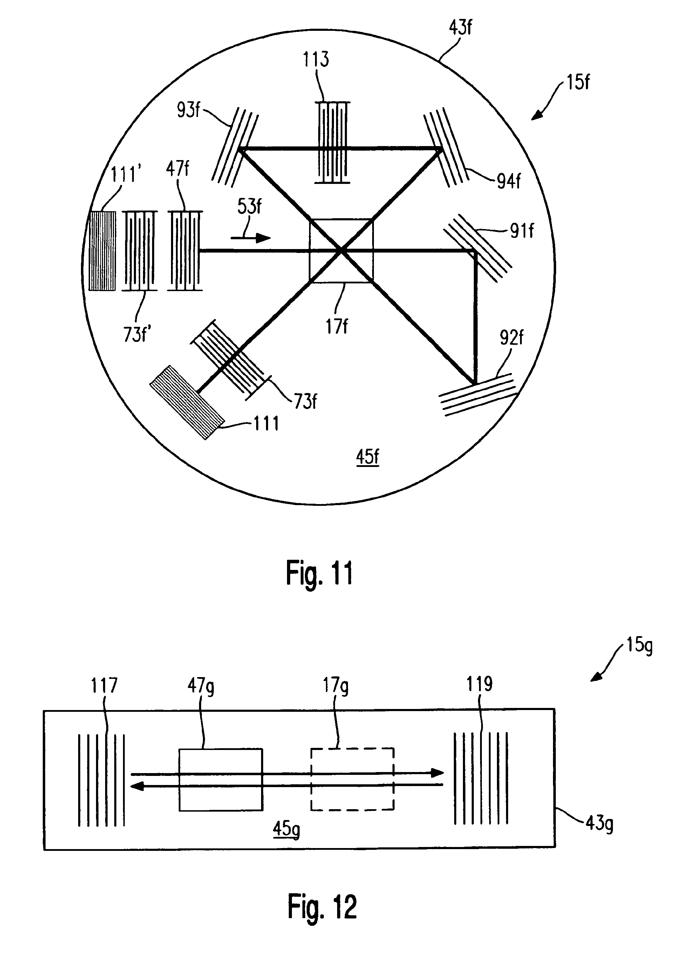

Figur 11 zeigt eine beugungsoptische Komponente 15f mit einem Substrat 43f, auf dessen Substratoberfläche 45f ein Wechselwirkungsbereich 17f vorgesehen ist. Der Wechselwirkungsbereich wird von einem Strahl Oberflächenwellen mehrmals in verschiedenen Richtungen durchlaufen. Hierzu emittiert eine Oberflächenwellenquelle 47f Oberflächenwellen in eine Vorzugsrichtung 53f direkt auf den Wechselwirkungsbereich 17f. Nach Durchlaufen des Wechselwirkungsbereichs 17f wird der Oberflächenwellenstrahl dann an einem Spiegel 91f um 90° abgelenkt, trifft auf einen weiteren Spiegel 92f, wird an diesem um 135° abgelenkt und durchläuft den Wechselwirkungsbereich 17f erneut, und zwar in eine Richtung, die um 135° verdreht zur Richtung 53f des ersten Durchlaufens des Wechselwirkungsbereichs orientiert ist. Nach dem erneuten Durchlaufen des Wechselwirkungsbereichs 17f trifft der Strahl auf einen weiteren Spiegel 93f, wird an diesem um 135° abgelenkt, trifft auf einen weiteren Spiegel 94f, an welchem er wiederum um 135° abgelenkt wird und daraufhin den Wechselwirkungsbereich 17f erneut durchläuft, und zwar in eine Richtung, die um 90° bezüglich der Richtung des zweiten Durchlaufs verdreht orientiert ist. Nach dem dritten Durchlaufen des Wechselwirkungsbereichs 17f durchläuft der Strahl einen Oberflächenwellenempfänger 73f, welcher ein Signal abgibt, welches die Intensität der Oberflächenwellen nach dem dritten Durchlaufen des Wechselwirkungsbereichs 17f repräsentiert. Nach Durchlaufen des Empfängers 73f wird der Strahl in einem separaten Oberflächenwellendämpfer 111 absorbiert.

Neben der Oberflächenwellenquelle 47f ist ein weiterer Oberflächenwellendämpfer 73f' angeordnet, welcher die Oberflächenwellen empfängt, die die Quelle 47f in die der Vorzugsrichtung 53f entgegengesetzte Richtung emittiert. Nach Durchlaufen des Empfängers 73f' werden diese Wellen dann ebenfalls in einem Oberflächenwellendämpfer 111' absorbiert.

Zwischen den Spiegeln 93f und 94f ist im Ausbreitungsweg der Oberflächenwellen eine weitere Oberflächenwellenquelle 113 angeordnet, welche von den Oberflächenwellen nach deren zweitem Durchgang durch den Wechselwirkungsbereich 17f durchlaufen wird und welche die Intensität dieser Oberflächenwellen erhöhen kann, so daß für den dritten Durchlauf durch den Wechselwirkungsbereich 17f eine einstellbar höhere Intensität an Oberflächenwellen zur Verfügung steht.

Eine Steuerung für diese beugungsoptische Komponente 15f kann die Ausgangssignale der Oberflächenwellenempfänger 73f und 73f' auslesen, um die Leistung bzw. Quellstärke der beiden Quellen 47f und 113 absolut und relativ zueinander einzustellen, und zwar im Hinblick auf eine gewünschte Gitterstruktur, welche durch die Oberflächenwellen in dem Wechselwirkungsbereich 17f gebildet wird. Hierbei kann die Intensität der beiden Oberflächenwellenquellen 47f und 113 relativ zueinander variiert werden, um die Beugungseffizienz in unterschiedlichen Raumrichtungen zu beeinflussen.

Eine in Figur 12 gezeigte beugungsoptische Komponente 15g umfaßt ein Substrat 43g, auf dessen Oberfläche 45g ein Wechselwirkungsbereich 17g vorgesehen ist, der innerhalb eines Oberflächenwellenresonators angeordnet ist, in dem stehende Oberflächenwellen erzeugbar sind. Hierzu sind auf der Substratoberfläche zwei sich gegenüberliegende Oberflächenwellenspiegel 117 und 119 vorgesehen, zwischen welchen Oberflächenwellen eines vorbestimmten Frequenzbandes hin und herlaufen bzw. dort ein stehendes Oberflächenwellenfeld ausbilden können. Zwischen den beiden Resonatorspiegeln 117, 119 ist der Wechselwirkungsbereich 17g angeordnet sowie weiter eine Oberflächenwellenquelle 47g, durch welche der Resonator mit Oberflächenwellen gespeist wird.

Der Wechselwirkungsbereich 17g wird von einem kontinuierlichen Lichtstrahl beleuchtet, welcher somit in dem Wechselwirkungsbereich eine Gitterstruktur sieht, deren Gitteramplitude zeitlich alternierend mit der doppelten Frequenz der Oberflächenwellen zu und abnimmt. Entsprechend ändert sich auch die von diesem Gitter bereitgestellte Beugungseffizienz mit der doppelten Frequenz der Oberflächenwellen.

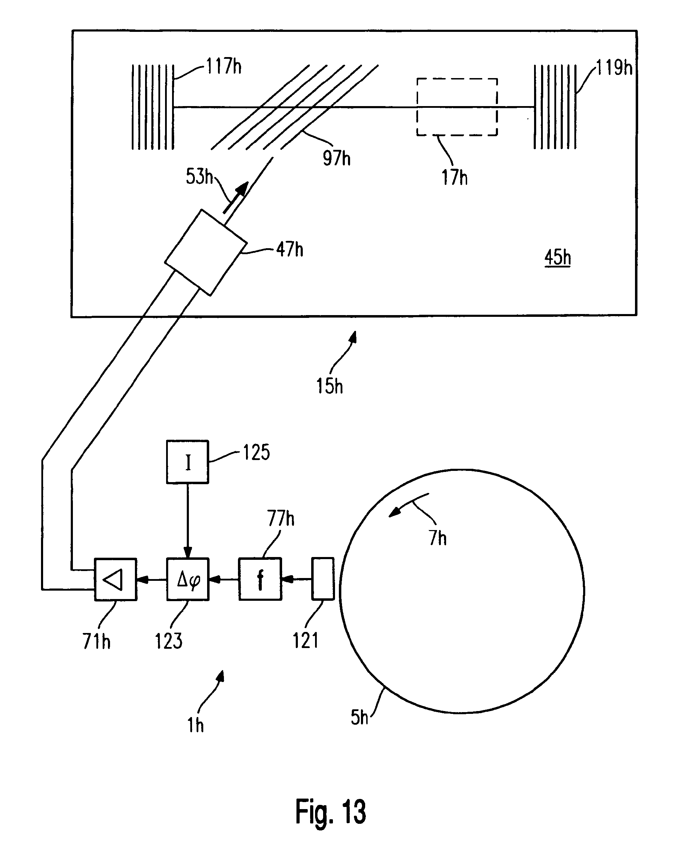

Figur 13 zeigt eine weitere beugungsoptische Komponente 15h, bei welcher in einem Wechselwirkungsbereich 17h auf einer Substratoberfläche 45h mittels zweier aufeinander zuweisender Spiegel 117h und 119h stehende Oberflächenwellen erzeugt werden. Im Unterschied zu der in Figur 12 gezeigten Ausführungsform ist hier allerdings eine Oberflächenwellenquelle 47h nicht innerhalb des Resonators angeordnet, sondern außerhalb desselben, wobei in eine Vorzugsrichtung 53h der Quelle 47h emittierte Oberflächenwellen auf einen Einkoppelspiegel 97h treffen, der innerhalb des Resonators, d.h. zwischen den beiden Spiegeln 117h und 119h, angeordnet ist und die von der Quelle 47h emittierten Oberflächenwellen in den Resonator einkoppelt, wo sich dann ein Feld stehender Oberflächenwellen ausbildet.

Die in Figur 13 gezeigte beugungsoptische Komponente 15h ist Teil eines Beleuchtungssystems 2h, welches als Lichtquelle eine Sychrotronstrahlungsquelle 5h aufweist, welche in Figur 13 lediglich schematisch dargestellt ist. In dem Synchrotron 5h laufen Bündel geladener Teilchen in Richtung des Pfeils 7h um und emittieren dadurch an einer in der Figur 13 nicht dargestellten Strahlposition zeitlich gepulste Synchrotronstrahlung, welche auf den Wechselwirkungsbereich 17h gerichtet ist. Hierbei ist eine nachfolgend beschriebene Steuerung vorgesehen, welche die Oberflächenwellenquelle 47h und das Synchrotron 5h derart miteinander synchronisiert, daß die von dem Synchrotron 5h emittierten Strahlungspulse immer dann auf den Wechselwirkungsbereich 17h treffen, wenn die Amplitude des Oberflächenwellengitters im wesentlichen maximal ist, um eine möglichst hohe Intensität der zur Verfügung stehenden Synchrotronstrahlung mit maximaler Beugungseffizienz abzulenken.

Hierzu ist an dem Synchrotron 5h ein Sensor 121 vorgesehen, welcher ein Meßsignal abgibt, das die zeitliche Abfolge der in dem Synchrotron umlaufenden Teilchenpakete und damit die zeitliche Abfolge der Strahlungspulse repräsentiert. Der Sensor 121 kann beispielsweise eine Strahl-Pickupspule oder ähnliches sein.

Das von dem Sensor 121 bereitgestellte Meßsignal wird einer Frequenzsteuerung 77h zugeführt, welche die Frequenz der von der Oberflächenwellenquelle 47h emittierten Oberflächenwellen bestimmt, wobei die Frequenz f der Oberflächenwellen auf die Hälfte der Frequenz der Strahlungspulse eingestellt wird. Das von der Frequenzsteuerung 77h ausgegebene Frequenzsignal wird einer Phasenschiebesteuerung 123 zugeführt, welche eine Phase Δϕ der von der Quelle 47h emittierten Oberflächenwellen einstellt und sodann einen Verstärker 71h ansteuert, welcher schließlich die Oberflächenwellenquelle 47h speist. Die Phasenschiebesteuerung 123 stellt die Phase Δϕ in Abhängigkeit eines von einem Strahlungssensor 125 registrierten Signal ein. Der Strahlungssensor 125 mißt die Intensität einer vorbestimmten Beugungsordnung der auf dem Wechselwirkungsbereich 17h fallenden Strahlung. Da die Intensität dieser Strahlung von der Beugungseffizienz es durch die Oberflächenwellen in dem Wechselwirkungsbereich 17h bereitgestellten Beugungsgitter abhängt, repräsentiert das von dem Strahlungssensor 125 ausgegebene Meßsignal die Beugungseffizienz des Gitters. Die Phasensteuerung 123 stellt dann die Phase Δϕ derart ein, daß die Beugungseffizienz maximal ist.

Die Phasenschiebesteuerung 123 kann auch dazu eingesetzt werden, den gebeugten Strahl auszuschalten, d.h. die Phase Δϕ so einzustellen, daß die Beugunseffizienz minimal ist. Dies kann beispielsweise dadurch geschehen, daß die Phase Δϕ so eingestellt wird, daß die Strahlungspulse immer dann auf den Wechselwirkungsbereich treffen, wenn die Amplitude der stehenden Wellen dort einen Wert von im wesentlichen Null aufweist.

Hierbei ist es auch möglich, für die Frequenz der Oberflächenwellen Vielfache der vorangehend beschriebenen Frequenz f, d.h. die Grundfrequenz der Strahlungspulse oder Harmonische davon einzusetzen.

In dem vorangehend beschriebenen Ausführungsbeispiel wird die Phasenschiebesteuerung 123 derart angesteuert, daß die von der Oberflächenwellenquelle 47h emittierten Oberflächenwellen phasenrichtig in den durch die Spiegel 117h und 119h gebildeten Oberflächenwellenresonator eingekoppelt werden. Die Phasenschiebesteuerung 123 stellt den Phasenwinkel Δϕ in Abhängigkeit von dem Strahlungsintensitätssenor 125 ein. Der Strahlungssensor 125 kann die Intensität der unter erster oder zweiter oder höherer Ordnung gebeugten Strahlung erfassen.

Alternativ ist es jedoch möglich, daß die Phasenschiebesteuerung 123 den Phasenwinkel Δϕ nicht in Abhängigkeit von einem Meßsignal eines Strahlungssensors einstellt, sondern in Abhängigkeit von einem Meßsignal, das durch einen Oberflächenwellenempfänger bereitgestellt wird, der die Amplitude der in dem Oberflächenwellenresonator auftretenden Oberflächenwellen erfaßt.

Eine solche Einstellung der Phasenlage einer Oberflächenwellenquelle durch eine Phasenschiebesteuerung in Abhängigkeit von dem Meßsignal eines Strahlungssensors oder eines Oberflächenwellenempfängers ist auf sämtliche vorangehend beschriebene Ausführungsbeispiele anwendbar, in denen entweder stehende Oberflächenwellen oder in einem geschlossenen Ausbreitungsweg umlaufende Oberflächenwellen erzeugt werden.

Ebenso ist es möglich, den Wechselwirkungsbereich des in Figur 13 gezeigten Resonators, d.h. einem von einer externen Oberflächenwellenquelle gespeisten Resonator, mit einer kontinuierlichen Strahlungsquelle zu beleuchten, wie dies für die Ausführungsform der Figur 12 beschrieben wurde, und es ist auch möglich, den Wechselwirkungsbereich der Ausführungsform der Figur 12 mit einer gepulsten Strahlungsquelle zu beleuchten, die auf die stehenden Oberflächenwellen synchronisiert ist, wie dies im Zusammenhang mit der in Figur 13 gezeigten Ausführungsform beschrieben wurde.

In den vorangehenden Ausführungsbeispielen wurden Ausbreitungsrichtungen der Oberflächenwellen meist durch Spiegel, welche unter einem Winkel von 45° zur ursprünglichen Ausbreitungsrichtung der Oberflächenwellen angeordnet sind, um 90° bezüglich ihrer ursprünglichen Ausbreitungsrichtung abgelenkt. Diese Darstellung erfolgte der Einfachheit halber. Es wird jedoch darauf hingewiesen, daß die Ausbreitung von Oberflächenwellen häufig durch anisotrope Effekte in dem Material des Substrats beeinflußt bzw. bestimmt wird. Deshalb ist es möglich, daß die aus der Optik bekannte Winkelbeziehung zwischen einfallendem und ausfallendem Strahl bei Reflexion an einem Spiegel hier bei Oberflächenwellen nicht erfüllt ist. Demgemäß ist ein Einfallswinkel von Oberflächenwellen auf einen Spiegel nicht immer gleich dem entsprechenden Ausfallswinkel. Auch ist es möglich, daß sich Oberflächenwellen auf einem Substrat, auf dem sie in eine erste Richtung mit vergleichsweise geringer Dämpfung propagieren, in eine hierzu orthogonal verlaufende Richtung schlecht ausbreiten, so daß in solchen Fällen vorteilhafterweise durch Spiegel eine Umlenkung in Richtungen erreicht wird, die nicht orthogonal zur ursprünglichen Ausbreitungsrichtung orientiert sind.

## Patentansprüche

1. Beleuchtungssystem zur Erzeugung eines kurzwelligen Lichtstrahls, umfassend eine Quelle (5, 11) für Strahlung mit einer Wellenlänge in einem Bereich von 0,1 nm bis 100 nm und eine beugungsoptische Komponente mit einem Wechselwirkungsbereich, welcher relativ zu der Quelle derart angeordnet ist, daß der aus der Strahlung der Quelle nach einer Wechselwirkung in dem Wechselwirkungsbereich zu erzeugende Lichtstrahl von dem Wechselwirkungsbereich ausgeht,
wobei die beugungsoptische Komponente eine Oberflächenwellen-Bauanordnung aufweist und die Oberflächenwellen-Bauanordnung ein Substrat (43) mit einer Oberfläche (45), welche den Wechselwirkungsbereich (17) bereitstellt, und eine mit einer einstellbaren Frequenz erregbare Oberflächenwellenquelle (47) zur Erzeugung von Oberflächenwellen auf der Oberfläche (45) des Substrats (43) derart umfaßt, daß in dem Wechselwirkungsbereich (17) durch die Oberflächenwellen eine Gitterstruktur zur Wechselwirkung mit der Strahlung bereitgestellt ist,
**dadurch gekennzeichnet, dass** die beugungsoptische Komponente ferner einen Oberflächenwellenempfänger (73) zum Empfang von von der Oberflächenwellenquelle (47) erzeugten Oberflächenwellen und zur Abgabe eines eine Amplitude der Oberflächenwellen an einem Ort des Oberflächenwellenempfängers (73) angebenden Meßsignals und eine die Frequenz (f) zur Erregung der Oberflächenwellenquelle (47) in Abhängigkeit von dem Meßsignal einstellende Steuerung (77) aufweist.

2. Beleuchtungssystem nach Anspruch 1, wobei die Steuerung (77) die Frequenz (f) derart einstellt, daß eine Amplitude der empfangenen Oberflächenwellen im wesentlichen maximal ist.

3. Beleuchtungssystem nach Anspruch 1 oder 2, wobei eine Amplitude der von der Oberflächenwellenquelle (47) erzeugten Oberflächenwellen in Abhängigkeit von der Frequenz (f) zu deren Erregung einen ersten Verlauf aufweist,
wobei eine Größe des Meßsignals in Abhängigkeit von der Frequenz (f) einen zweiten Verlauf (84) aufweist,
wobei der erste Verlauf und der zweite Verlauf (84) jeweils eine um jeweils eine Mittelfrequenz beidseits mit einer Frequenzbreite (δf, Δf) abfallende Charakteristik aufweisen und
wobei die Frequenzbreite (Δf) des zweiten Verlaufs (84) größer ist als die Frequenzbreite (δf) des ersten Verlaufs.

4. Beleuchtungssystem nach Anspruch 3, wobei die Steuerung (77) die Frequenz (f) ferner in Abhängigkeit von dem zweiten Verlauf (84) steuert.

5. Beleuchtungssystem nach einem der Ansprüche 1 bis 4, wobei die beugungsoptische Komponente ferner einen außerhalb des Wechselwirkungsbereichs (17) angeordneten Oberflächenwellendämpfer (73, 87; 111, 111') zum Dämpfen von Oberflächenwellen aufweist, und
wobei der Oberflächenwellendämpfer (73, 87; 111, 111') einen akustoelektrischen Wandler zur Umwandlung von Energie der Oberflächenwellen am Ort des akustoelektrischen Wandlers in elektrische Energie umfaßt.

6. Beleuchtungssystem nach Anspruch 5, wobei der akustoelektrische Wandler (73) wenigstens zwei Anschlüsse (75, 76) zur Bereitstellung der elektrischen Energie und ferner eine an die beiden Anschlüsse (75, 76) angeschlossene Widerstandsschaltung (81) zur Dissipation der elektrischen Energie umfaßt.

7. Beleuchtungssystem nach Anspruch 6, wobei die Widerstandsschaltung (81) eine elektrische Impedanz aufweist, die an eine Impedanz des akustoelektrischen Wandlers (73) zwischen den beiden Anschlüssen (75, 76) derart angepaßt ist, daß die in der Widerstandsschaltung (81) dissipierte Energie maximal ist.

8. Beleuchtungssystem nach Anspruch 7, wobei die elektrische Impedanz der Widerstandsschaltung (81) und die elektrische Impedanz des akustoelektrischen Wandlers (73) zueinander konjugiert komplexe Werte aufweisen.

9. Beleuchtungssystem nach einem der Ansprüche 5 bis 8, wobei die Oberflächenwellenquelle (47) einen elektroakustischen Wandler umfaßt, wobei der elektroakustische Wandler der Oberflächenwellenquelle (47) und der akustoelektrische Wandler des Oberflächenwellendämpfers (73) jeweils eine Elektrodenstruktur aufweisen, die jeweils bereichsweise eine Mehrzahl Teilelektroden (62, 63, 64, 65, 66, 76) umfaßt, welche periodisch mit Abstand zu benachbarten Teilelektroden angeordnet sind, wobei ein Bereich der Elektrodenstruktur des elektroakustischen Wandlers und ein Bereich der Elektrodenstruktur des akustoelektrischen Wandlers einander zugeordnet sind und wobei sich die Anordnungsperioden (Λ₁, Λ₂) der Teilelektroden (62, 63, 64, 65, 66, 76) der einander zugeordneten Bereiche unterscheiden.

10. Beleuchtungssystem nach Anspruch 9, wobei sich die die Anordnungsperioden (Λ₁, Λ₂) der einander zugeordneten Bereiche um 0,01 % bis 0,5 %, insbesondere um 0,01 % bis 0,05 %, 0,05 % bis 0,15 % oder 0,15 % bis 0,5 %, unterscheiden.

11. Beleuchtungssystem nach einem der Ansprüche 5 bis 10, wobei der akustoelektrischen Wandler des Oberflächenwellendämpfers (73) eine Richtcharakteristik aufweist und Oberflächenwellen, die aus einer Vorzugsrichtung (53) auf den Oberflächenwellendämpfer (73) treffen, stärker dämpft als aus einer hierzu entgegengesetzten Richtung eintreffende Oberflächenwellen.

12. Beleuchtungssystem nach einem der Ansprüche 5 bis 11, wobei der Wechselwirkungsbereich (17) auf einer Verbindungslinie zwischen der Oberflächenwellenquelle (47) und dem Oberflächenwellendämpfer (73) angeordnet ist.

13. Beleuchtungssystem nach einem der Ansprüche 5 bis 12, wobei die Oberflächenwellenquelle (74) auf einer Verbindungslinie zwischen dem Wechselwirkungsbereich (17) und dem Oberflächenwellendämpfer (87) angeordnet ist.

14. Beleuchtungssystem nach einem der Ansprüche 1 bis 13, wobei die beugungsoptische Komponente ferner eine Mehrzahl von auf dem Substrat (43a; 43c) derart angeordneten Oberflächenwellenspiegeln (91, 92, 93, 94; 91c, 92c, 93c, 94c) aufweist, daß sie einen geschlossenen Ausbreitungsweg für die Oberflächenwellen bereitstellen,
wobei der Wechselwirkungsbereich (17a; 17c) in dem geschlossenen Ausbreitungsweg liegt.

15. Beleuchtungssystem nach Anspruch 14, wobei die Oberflächenwellenquelle (47a) eine Richtcharakteristik aufweist und Oberflächenwellen in eine Vorzugsrichtung (53a) stärker emittiert als in eine hierzu entgegengesetzte Richtung und wobei die Oberflächenwellenquelle (45a) in dem geschlossenen Ausbreitungsweg liegt.

16. Beleuchtungssystem nach Anspruch 14, wobei die Oberflächenwellenquelle (47c) außerhalb des geschlossenen Ausbreitungswegs angeordnet ist und die von der Oberflächenwellenquelle (47c) emittierten Oberflächenwellen in den geschlossenen Ausbreitungsweg eingekoppelt werden.

17. Beleuchtungssystem nach Anspruch 16, wobei ein weiterer Oberflächenwellenspiegel (87) zur Einkopplung der von der Oberflächenwellenquelle (47c) emittierten Oberflächenwellen in den geschlossenen Ausbreitungsweg vorgesehen ist.

18. Beleuchtungssystem nach einem der Ansprüche 14 bis 17, wobei die Oberflächenwellenspiegel (91d, 92d, 93d, 94d, 101, 102, 103, 104) derart angeordnet sind, daß der Ausbreitungsweg den Wechselwirkungsbereich (17d) mehrmals aus jeweils verschiedenen Richtungen (105, 106) durchläuft.

19. Beleuchtungssystem nach einem der Ansprüche 1 bis 18, wobei die Gitterstruktur aus stehenden Oberflächenwellen gebildet ist.

20. Beleuchtungssystem nach Anspruch 19, wobei der Wechselwirkungsbereich (17g) auf einer Verbindungslinie zwischen der Oberflächenwellenquelle (47g) und einem Oberflächenwellenspiegel (119) angeordnet ist, der von der Oberflächenwellenquelle (47g) emittierte Oberflächenwellen zurück zu dem Wechselwirkungsbereich (17g) reflektiert.

21. Beleuchtungssystem nach Anspruch 19 oder 20, wobei der Wechselwirkungsbereich (17h) innerhalb eines Oberflächenwellenresonators (117, 119) angeordnet ist, in den von der Oberflächenwellenquelle (47h) emittierte Oberflächenwellen eingekoppelt werden.

22. Beleuchtungssystem nach Anspruch 21, wobei der Oberflächenwellenresonator durch Oberflächenwellenspiegel (117, 119) gebildet ist.

23. Beleuchtungssystem nach Anspruch 21 oder 22, wobei ein weiterer Oberflächenwellenspiegel (97h) zur Einkopplung der von der Oberflächenwellenquelle (47h) emittierten Oberflächenwellen in den Oberflächenwellenresonator (117, 119) vorgesehen ist.

24. Beleuchtungssystem nach einem der Ansprüche 19 bis 23, wobei die Quelle für Strahlung eine gepulste Strahlungsquelle (5h) ist, deren Strahlung auf den Wechselwirkungsbereich (17h) der Oberflächenwellen-Bauanordnung gerichtet ist und deren Strahlungspulse mit der Oberflächenwellen-Bauanordnung derart synchronisiert sind, daß die Pulse innerhalb von Zeitperioden auf den Wechselwirkungsbereich (17h) treffen, wenn Amplituden der stehenden Oberflächenwellen einen vorbestimmten Schwellenwert überschreiten.

25. Beleuchtungssystem nach Anspruch 24, wobei die Oberflächenwellenquelle (47) eine Ansteuervorrichtung (77h, 123) zur Einstellung einer Frequenz (f) und einer Phasenlage (Δϕ) der erzeugten Oberflächenwellen aufweist und wobei die Ansteuervorrichtung (77h, 123) die Frequenz (f) und die Phasenlage (Δϕ) in Abhängigkeit von einer Pulsfolge der Strahlungsquelle (5h) derart einstellt, daß eine Intensität an Strahlung, die durch die Gitterstruktur mit einer vorbestimmten Beugungsordnung gebeugt wird, einen vorbestimmten Wert, insbesondere im wesentlichen einen Maximalwert, aufweist.

26. Beleuchtungssystem nach einem der Ansprüche 1 bis 25, wobei die Strahlungsquelle eine Synchrotronstrahlungsquelle (5h) ist.

27. Belichtungssystem umfassend ein Beleuchtungssystem nach einem der Ansprüche 1 bis 26 sowie
wenigstens ein Kondensorsystem (25), eine mit einem abzubildenden Muster versehene Maske (27), ein Abbildungssystem (37) und einen Substrathalter (39),
wobei das Kondensorsystem (25) und die Maske (27) derart angeordnet sind, daß in dem Wechselwirkungsbereich (17) in unterschiedliche Raumrichtungen gebeugte Strahlung (+1, 0, -1) der Strahlungsquelle (5, 11) auf die Maske (27) gerichtet ist, und
wobei das Abbildungssystem (37) und der Substrathalter (39) derart angeordnet sind, daß von der Maske (27) reflektierte Strahlung auf ein an dem Substrathalter anbringbares Substrat (39) abgebildet ist.

28. Verfahren zur Herstellung eines Bauelements, umfassend wenigstens einen photolithographischen Schritt, wobei der photolithographische Schritt umfaßt:
Bereitstellen des Belichtungssystems nach Anspruch 27,
Anbringen eines mit einer strahlungsempfindlichen Schicht versehenen Substrats (39) an dem Substrathalter, und
Belichten des strahlungsempfindlichen Substrats mit an dem Wechselwirkungsbereich in unterschiedliche Raumrichtungen gebeugter Strahlung der Strahlungsquelle (5, 11).

## Claims

1. Illumination system for generating a short-wavelength light beam, comprising a source (5, 11) for radiation having a wavelength in a range from 0.1 nm to 100 nm and an optically diffracting component comprising an interaction area that is arranged relative to the source in such a way that the light beam to be generated from the radiation from the source following an interaction in the interaction area emerges from the interaction area,
wherein the optically diffracting component has a surface wave assembly arrangement and said surface wave assembly arrangement comprises a substrate (43) comprising a surface (45) that provides the interaction area (17), and a surface wave source (47) that is excitable with an adjustable frequency for generating surface waves on the surface (45) of the substrate (43), in such a way that a lattice structure is provided by the surface waves in the interaction area (17) for interacting with the radiation,
**characterized in that**
the optically diffracting component additionally comprises a surface wave receiver (73), for receiving surface waves generated by the surface wave source (47) and for outputting a measurement signal indicating an amplitude of the surface waves at a location of the surface wave receiver (73), and a control device (77) adjusting the frequency (f) for exciting the surface wave source (47) in accordance with said measurement signal.

2. Illumination system according to Claim 1, wherein the control device (77) adjusts the frequency (f) in such a way that an amplitude of the received surface waves is essentially a maximum.

3. Illumination system according to Claim 1 or 2, wherein an amplitude of the surface waves generated by the surface wave source (47) has a first dependence of the frequency (f) for exciting said source,
wherein a magnitude of the measurement signal has a second dependence (84) of the frequency (f),
wherein the first dependence and the second dependence (84) each have a characteristic that falls off on both sides of a respective centre frequency with a bandwidth (δf, Δf), and
wherein the bandwidth (Δf) of the second dependence curve (84) is larger than the bandwidth (δf) of the first dependence curve.

4. Illumination system according to Claim 3, wherein the control device (77) additionally controls the frequency (f) with respect to the second dependence curve (84).

5. Illumination system according to any one of Claims 1 to 4, wherein the optically diffracting component additionally has a surface wave attenuator (73, 87; 111, 111') arranged outside the interaction area (17) for attenuating surface waves, and
wherein the surface wave attenuator (73, 87; 111, 111') comprises an acousto-electric transducer for converting energy from the surface waves at the site of the acousto-electric transducer into electrical energy.

6. Illumination system according to Claim 5, wherein the acousto-electric transducer (73) comprises at least two terminals (75, 76) for supplying the electrical energy, and additionally a resistance circuit (81) connected to both the terminals (75, 76) for dissipating the electrical energy.

7. Illumination system according to Claim 6, wherein the resistance circuit (81) has an electrical impedance which is matched to an impedance of the acousto-electric transducer (73) between the two terminals (75, 76) in such a way that the energy dissipated in the resistance circuit (81) is a maximum.

8. Illumination system according to Claim 7, wherein the electrical impedance of the resistance circuit (81) and the electrical impedance of the acousto-electric transducer (73) have complex conjugate values with respect to each other.

9. Illumination system according to any one of Claims 5 to 8,
wherein the surface wave source (47) comprises an electro-acoustic transducer, wherein said electro-acoustic transducer of the surface wave source (47) and the acousto-electric transducer of the surface wave attenuator (73) each have an electrode structure which in some regions comprises a plurality of sub-electrodes (62, 63, 64, 65, 66, 76) arranged periodically, spaced a distance apart from adjacent sub-electrodes, wherein one region of the electrode structure of the electro-acoustic transducer and one region of the electrode structure of the acousto-electric transducer are associated with each other and wherein the arrangement periods (A1, A2) of the sub-electrodes (62, 63, 64, 65, 66, 76) of the mutually associated regions are different.

10. Illumination system according to Claim 9, wherein the arrangement periods (Λ1, Λ2) of the mutually associated regions differ by 0.01 % to 0.5 %, in particular by 0.01 % to 0.05 %, 0.05 % to 0.15 % or 0.15 % to 0.5 %.

11. Illumination system according to any one of Claims 5 to 10, wherein the acousto-electric transducer of the surface wave attenuator (73) has a directivity, and attenuates surface waves striking the surface wave attenuator (73) from a preferred direction (53) more strongly than surface waves incident from a direction opposite thereto.

12. Illumination system according to any one of Claims 5 to 11, wherein the interaction area (17) is arranged on a connecting line between the surface wave source (47) and the surface wave attenuator (73).

13. Illumination system according to any one of Claims 5 to 12, wherein the surface wave source (74) is arranged on a connecting line between the interaction area (17)' and the surface wave attenuator (87).

14. Illumination system according to any one of Claims 1 to 13, wherein the optically diffracting component additionally has a plurality of surface wave reflectors (91, 92, 93, 94; 91c, 92c, 93c, 94c) arranged on the substrate (43a; 43c) in such a way that they provide a closed propagation path for the surface waves,
wherein the interaction area (17a; 17c) lies in the closed propagation path.

15. Illumination system according to Claim 14, wherein the surface wave source (47a) has a directivity and surface waves are emitted in a preferred direction (53a) more strongly than in a direction opposite thereto, and wherein the surface wave source (45a) lies in the closed propagation path.

16. Illumination system according to Claim 14, wherein the surface wave source (47c) is arranged outside the closed propagation path and the surface waves emitted by the surface wave source (47c) are coupled into the closed propagation path.

17. Illumination system according to Claim 16, wherein a further surface wave reflector (87) is provided for coupling the surface waves emitted by the surface wave source (47c) into the closed propagation path.

18. Illumination system according to any one of Claims 14 to 17, wherein the surface wave reflectors (91d, 92d, 93d, 94d, 101, 102, 103, 104) are arranged in such a way that the propagation path passes through the interaction area (17d) multiple times, from different directions (105, 106).

19. Illumination system according to any one of Claims 1 to 18, wherein the lattice structure is formed by standing surface waves.

20. Illumination system according to Claim 19, wherein the interaction area (17g) is arranged on a connecting line between the surface wave source (47g) and a surface wave reflector (119), which reflects surface waves emitted by the surface wave source (47g) back to the interaction area (17g).

21. Illumination system according to Claim 19 or 20, wherein the interaction area (17h) is arranged inside a surface wave resonator (117, 119), into which surface waves emitted by the surface wave source (47h) are coupled.

22. Illumination system according to Claim 21, wherein the surface wave resonator is formed by surface wave reflectors (117, 119).

23. Illumination system according to Claim 21 or 22, wherein a further surface wave reflector (97h) is provided for coupling the surface waves emitted by the surface wave source (47h) into the surface wave resonator (117, 119) .

24. Illumination system according to any one of Claims 19 to 23, wherein the source of radiation is a pulsed radiation source, the radiation of which is directed towards the interaction area (17h) of the surface wave assembly arrangement, and the radiation pulses therefrom are synchronised with the surface wave assembly arrangement in such a way that the pulses strike the interaction area (17h) within periods of time when amplitudes of the standing surface waves exceed a pre-defined threshold value.

25. Illumination system according to Claim 24, wherein the surface wave source (47) has a control device (77h, 123) for setting a frequency (f) and a phase difference (Δϕ) of the generated surface waves, and wherein said control device (77h, 123) sets the frequency (f) and the phase difference (Δϕ) in response to a pulse train of the radiation source (5h) in such a way that an intensity of radiation which is dispersed by the lattice structure with a pre-defined dispersion order has a pre-defined value, in particular essentially a maximum value.

26. Illumination system according to any one of Claims 1 to 25, wherein the radiation source is a synchrotron radiation source (5h).

27. Exposure system comprising an illumination system according to any one of Claims 1 to 26 and at least one condenser-lens system (25), a mask (27) with a pattern to be reproduced, a reproduction system (37) and a substrate holder (39),
wherein said condenser-lens system (25) and mask (27) are arranged in such a way that radiation from the radiation source (5, 11), dispersed in different spatial directions (+1, 0, -1) in the interaction area (17), is directed towards the mask (27), and
wherein the reproduction system (37) and the substrate holder (39) are arranged in such a way that radiation reflected by the mask (27) is imaged on a substrate (39) that can be applied to the substrate holder.

28. Method for fabricating a component, comprising at least one photolithographic step, said photolithographic step comprising:
provision of the exposure system according to Claim 27,
application of a substrate (39) provided with a radiation sensitive layer to the substrate holder, and
exposure of the radiation sensitive substrate with radiation from the radiation source (5, 11) dispersed in different spatial directions at the interaction area.

## Revendications

1. Système d'illumination permettant de générer un rayon lumineux de faible longueur d'onde courte, comprenant une source (5, 11) de rayonnement ayant une longueur d'onde dans une gamme de 0,1 nm à 100 nm, et un composant de diffraction optique comportant une zone d'interaction, qui est disposé par rapport à la source de façon à ce que le rayon lumineux, qui doit être généré depuis le rayonnement de la source après une interaction dans la zone d'interaction, parte de la zone d'interaction,
dans lequel la composante optique de diffraction présente une configuration d'ondes de surface, et la configuration d'ondes de surface comprend un substrat (43) présentant une surface (45) qui met à disposition la zone d'interaction (17), et une source d'ondes de surface (47) pouvant être excitée avec une fréquence réglable et permettant de générer des ondes de surface sur la surface (45) du substrat (43) de façon telle que dans la zone d'interaction (17) est mise à disposition, par les ondes de surface, une structure de grille pour interagir avec le rayonnement,
**caractérisé en ce que** le composant optique de diffraction comprend de plus un récepteur d'ondes de surface (73) destiné à recevoir les ondes de surface générées par la source d'ondes de surface (47) et à émettre un signal de mesure qui indique une amplitude des ondes de surface en un emplacement du récepteur d'ondes de surface (73), et une commande (77) qui règle la fréquence (f) d'excitation de la source d'ondes de surface (47) en fonction du signal de mesure.

2. Système d'illumination selon la revendication 1, dans lequel la commande (77) règle la fréquence (f) de façon telle qu'une amplitude des ondes de surface reçues est essentiellement maximale.

3. Système d'illumination selon la revendication 1 ou 2, dans lequel une amplitude des ondes de surface générées par la source d'ondes de surface (47) présente un premier profil en fonction de la fréquence (f) de leur excitation,
dans lequel une grandeur du signal de mesure présente un second profil (84) en fonction de la fréquence (f),
dans lequel le premier et le second profils (84) présentent une caractéristique qui diminue de respectivement une moyenne fréquence des deux côtés avec une largeur de fréquence (δf, Δf), et
dans lequel la largeur de fréquence (Δf) du second profil (84) est supérieure à la largeur de fréquence (δf) du premier profil.

4. Système d'illumination selon la revendication 3, dans lequel la commande (77) commande en outre la fréquence (f) en fonction du second profil (84).

5. Système d'illumination selon l'une des revendications 1 à 4, dans lequel le composant optique de diffraction comprend en outre un amortisseur d'ondes de surface (73, 87 ; 111, 111') disposé en-dehors de la zone d'interaction, destiné à amortir des ondes de surface, et
dans lequel l'amortisseur d'ondes de surface (73, 87 ; 111, 111') comprend un convertisseur acousto-électrique destiné à convertir l'énergie des ondes de surface à l'emplacement du convertisseur acousto-électrique en une énergie électrique.

6. Système d'illumination selon la revendication 5, dans lequel le convertisseur acousto-électrique (73) comprend au moins deux sorties (75, 76) pour la mise à disposition de l'énergie électrique et de plus un circuit résistant (81) raccordé aux deux sorties (75, 76) destiné à la dissipation de l'énergie électrique.

7. Système d'illumination selon la revendication 6, dans lequel le circuit résistant (81) présente une impédance électrique qui est adaptée à une impédance du convertisseur acousto-électrique (73) entre les deux sorties (75, 76) de façon à ce que l'énergie dissipée dans le circuit résistant (81) soit maximale.

8. Système d'illumination selon la revendication 7, dans lequel l'impédance électrique du circuit résistant (81) et l'impédance électrique du convertisseur acousto-électrique (73) présentent conjuguées l'une à l'autre des valeurs complexes.

9. Système d'illumination selon une ou plusieurs des revendications 5 à 8, dans lequel la source des ondes de surface (47) comprend un convertisseur électroacoustique, dans lequel le convertisseur électroacoustique de la source d'ondes de surface (47) et le convertisseur acousto-électrique de l'amortisseur d'ondes de surface (73) présentent respectivement une structure d'électrodes qui comporte respectivement par zones plusieurs électrodes partielles (62, 63, 64, 65, 66, 76) qui sont disposées périodiquement avec un écart aux électrodes voisines, dans lequel une zone de la structure d'électrodes du convertisseur électroacoustique et une zone de la structure d'électrodes du convertisseur acousto-électrique sont coordonnées l'une à l'autre et dans lequel les périodes de disposition (Λ₁, Λ₂) des électrodes partielles (62, 63, 64, 65, 66, 76) des zones coordonnées les unes aux autres diffèrent.

10. Système d'illumination selon la revendication 9, dans lequel les périodes de disposition (Λ₁, Λ₂) des zones coordonnées aux autres diffèrent de 0,01 % à 0,5 %, en particulier de 0,01 % à 0,05 %, de 0,05 % à 0,15 %, ou de 0,15 % à 0,5 %.

11. Système d'illumination selon l'une des revendications 5 à 10, dans lequel le convertisseur acousto-électrique de l'amortisseur d'ondes de surface (73) présente une directivité et amortit plus les ondes de surface qui atteignent depuis une direction préférentielle (53) l'amortisseur d'ondes de surface (73) que les ondes de surface l'atteignant depuis une direction opposée à celle-ci.

12. Système d'illumination selon l'une des revendications 5 à 11, dans lequel la zone d'interaction (17) est disposée sur une ligne de jonction entre la source d'ondes de surface (47) et l'amortisseur d'ondes de surface (73).

13. Système d'illumination selon l'une des revendications 5 à 12, dans lequel la source d'ondes de surface (74) est disposée sur une ligne de jonction entre la zone d'interaction (17) et l'amortisseur d'ondes de surface (87).

14. Système d'illumination selon l'une des revendications 1 à 13, dans lequel le composant optique de diffraction présente en outre plusieurs miroirs d'ondes de surface (91, 92, 93, 94 ; 91c, 92c, 93c, 94c) disposés sur le substrat (43a ; 43c) de façon telle qu'ils mettent à disposition un trajet de propagation fermé des ondes de surface,
dans lequel la zone d'interaction (17a ; 17c) repose dans le trajet de propagation fermé.

15. Système d'illumination selon la revendication 14, dans lequel la source d'ondes de surface (47a) présente une directivité et les ondes de surface émettent plus fortement dans une direction préférentielle (53a) que dans une direction qui lui est opposée, et dans lequel la source d'ondes de surface (45a) repose dans le trajet de propagation fermé.

16. Système d'illumination selon la revendication 14, dans lequel la source d'ondes de surface (47c) est disposée à l'extérieur du trajet de propagation fermé et les ondes de surface émises par la source d'ondes de surface (47c) sont couplées dans le trajet de propagation fermé.

17. Système d'illumination selon la revendication 16, dans lequel un autre miroir d'ondes de surface (87) est prévu pour coupler les ondes de surface émises par la source d'ondes de surface (47c) dans le trajet de propagation fermé.

18. Système d'illumination selon l'une des revendications 14 à 17, dans lequel les miroirs d'ondes de surface (91d, 92d, 93d, 94d, 101, 102, 103, 104) sont disposés de façon telle que le trajet de propagation parcourt la zone d'interaction (17d) plusieurs fois depuis des directions respectivement différentes (105, 106).

19. Système d'illumination selon l'une des revendications 1 à 18, dans lequel la structure de grille est formée d'ondes de surface stationnaires.

20. Système d'illumination selon la revendication 19, dans lequel la zone d'interaction (17g) est disposée sur une ligne de jonction entre la source d'ondes de surface (47g) et un miroir d'ondes de surface (119) qui réfléchit vers la zone d'interaction (17g) des ondes de surface émises par la source d'ondes de surface (47g).

21. Système d'illumination selon la revendication 19 ou 20, dans lequel la zone d'interaction (17h) est disposée au sein d'un résonateur d'ondes de surface (117, 119) dans lequel les ondes de surface émises par la source d'ondes de surface (47h) sont couplées.

22. Système d'illumination selon la revendication 21, dans lequel le résonateur d'ondes de surface est formé par des miroirs d'ondes de surface (117, 119).

23. Système d'illumination selon la revendication 21 ou 22, dans lequel un autre miroir d'ondes de surface (97h) est prévu pour coupler les ondes de surface émises par la source d'ondes de surface (47h) dans le résonateur d'ondes de surface (117, 119).

24. Système d'illumination selon l'une des revendications 19 à 23, dans lequel la source du rayonnement est une source de rayonnement commandée par impulsion (5h) dont le rayonnement est dirigé sur la zone d'interaction (17h) de la disposition d'ondes de surface et dont les impulsions de rayonnement sont synchronisées avec la disposition d'ondes de surface de façon telle que les impulsions atteignent la zone d'interaction (17h) au sein d'une période lorsque les amplitudes des ondes de surface stationnaires dépassent une valeur seuil prédéterminée.

25. Système d'illumination selon la revendication 24, dans lequel la source d'ondes de surface (47) présente un dispositif de commande (77h, 123) pour le réglage d'une fréquence (f) et d'une relation de phase (Δϕ) des ondes de surface générées, et dans lequel le dispositif de commande (77h, 123) règle la fréquence (f) et la relation de phase (Δϕ) en fonction d'un train d'impulsions de la source de rayonnement (5h) de façon à ce qu'une intensité du rayonnement qui est diffracté par la structure de grille selon un ordre de diffraction prédéterminé présente une valeur prédéterminée, en particulier essentiellement une valeur maximale.

26. Système d'illumination selon l'une des revendications 1 à 25, dans lequel la source de rayonnement est une source de rayonnement synchrotron (5h).

27. Système d'exposition comprenant un système d'illumination selon l'une des revendications 1 à 26, ainsi que
au moins un système de condenseur (25), un masque muni d'un modèle à reproduire (27), un système de reproduction (37) et un support de substrat (39),
dans lequel le système de condenseur (25) et le masque (27) sont disposés de façon telle que dans la zone d'interaction (17), le rayonnement diffracté dans différentes directions spatiales (+1, 0, -1) de la source de rayonnement (5, 11) est dirigé sur le masque (27), et
dans lequel le système de reproduction (37) et le support de substrat (39) sont disposés de façon telle que le rayonnement réfléchi par le masque (27) est reproduit sur un substrat (39) applicable sur le support de substrat.

28. Procédé de fabrication d'un composant, comprenant au moins une étape de photolithographie, dans lequel l'étape de photolithographie comprend :
la mise à disposition du système d'exposition selon la revendication 27,
l'application d'un substrat (39) muni d'une couche photosensible sur le support de substrat, et
l'exposition du substrat photosensible avec un rayonnement de la source de rayonnement (5, 11) diffracté au niveau de la zone d'interaction dans différentes directions spatiales.
